# EUROPÄISCHE PATENTANMELDUNG

(11) **EP 4 614 164 A1**
(43) Veröffentlichungstag der Anmeldung: **10.09.2025**
(21) Anmeldenummer: 24162478.2
(22) Anmeldetag: 08.03.2024
(51) Int. Cl.: G01R 19/25, G01R 29/08

(54) **ERFASSUNGSVORRICHTUNG, ÜBERWACHUNGSVORRICHTUNG, HALTERUNG, ENERGIEVERSORGUNGSSYSTEM, ERFASSUNGSVERFAHREN, ÜBERWACHUNGSVERFAHREN UND COMPUTER PROGRAMM**

(71) Anmelder: Deutsche Telekom AG, 53113 Bonn (DE)
(72) Erfinder: BERGNER, Andreas, 12165 Berlin (DE)
(74) Vertreter: 2SPL Patentanwälte PartG mbB

(57) **Zusammenfassung**

Die vorliegende Offenbarung betrifft eine Erfassungsvorrichtung, eine Überwachungsvorrichtung, eine Halterung, ein Energieversorgungssystem, ein Erfassungsverfahren, ein Überwachungsverfahren und ein Computer Programm. Die Erfassungsvorrichtung (10) zur Erfassung von Information über einen Signalverlaufs in einer Energieversorgungsleitung umfasst ein oder mehreren Sensorelemente (12), die ausgebildet sind, um einen zeitlichen Verlauf einer für den Signalverlauf charakteristischen Feldgröße in einem Abstand von der Energieversorgungsleitung zu detektieren; ein oder mehrere Schnittstellen (16), die ausgebildet sind, um Information über den zeitlichen Verlauf der Feldgröße in einem Kommunikationsnetzwerk zu kommunizieren; und ein oder mehrere Signalverarbeitungskomponenten (14), die ausgebildet sind, um über die ein oder mehreren Sensorelemente den zeitlichen Verlauf der Feldgröße zu erfassen, um Information über den zeitlichen Verlauf der Feldgröße zu generieren und um die Information über den zeitlichen Verlauf der Feldgröße über die ein oder mehreren Schnittstellen in dem Kommunikationsnetzwerk zu kommunizieren.

## Beschreibung

### Technisches Gebiet

Die vorliegende Offenbarung betrifft eine Erfassungsvorrichtung, eine Überwachungsvorrichtung, eine Halterung, ein Energieversorgungssystem, ein Erfassungsverfahren, ein Überwachungsverfahren und ein Computer Programm, insbesondere aber nicht ausschließlich, ein Konzept zur Überwachung einer Energieversorgungsleitung durch Erfassung von Feldgrößen in einem Abstand zur Energieversorgungsleitung.

### Hintergrund

Freileitungen zur Energieversorgung müssen dauerhaft überwacht werden. Im Falle eines Kurzschlusses (Spannungseinbruch), muss der lokal verantwortliche Netzbetreiber schnellstmöglich den Betrieb innerhalb eines Zeitraums von 3 Stunden wiederherstellen. In der Regel sind Freileitungen schwer zugänglich und der Fehlerort schlecht eingrenzbar. Es gibt bereits verschiedene Produkte, die bei den Energienetzbetreibern das Problem lösen. Dabei handelt es sich beispielsweise um Sensoren in Gehäusen, die direkt an den Freileitungen angebracht werden.

Der Nachteil dieser Lösungen besteht darin, dass der Kurzschlussanzeiger immer an der jeweiligen Leitung in einer Höhe von meist mehr als 6-8 Metern installiert werden muss. Die Montage ist daher zeitintensiv und ein Zurücksetzen (auch engl. RESET) der Geräte ist teilweise eine Herausforderung, da diese Arbeiten unter Einhaltung von Schutzanforderungen der VDE-Norm (Verband Deutscher Elektrotechniker) 0105-100 durchzuführen sind. Insbesondere kann es erforderlich sein, dass das Netz bei Arbeiten an den Leitungen abgeschaltet wird.

### Zusammenfassung

Ausführungsbeispiele basieren auf der Erkenntnis, dass es viel aufwandsgünstiger ist, wenn man den Signalverlauf in einer Freileitung aus einer gewissen Entfernung bestimmt. Ausführungsbeispiele erfassen daher eine Feldgröße und können darüber hinaus ein autarkes System nutzen, das Änderungen in den Signalverläufen erkennen kann und nicht Bestandteil der Freileitung ist. Ausführungsbeispiele schaffen daher ein Verfahren zur Überwachung von Freileitungen zur Energieversorgung mit Hilfe von Feldstärkemessung und können ferner von dem Superpositionsprinzip und/oder Mustererkennung Gebrauch machen.

Ausführungsbeispiele schaffen eine Erfassungsvorrichtung zur Erfassung von Information über einen Signalverlauf in einer Energieversorgungsleitung. Die Erfassungsvorrichtung umfasst ein oder mehrere Sensorelemente, die ausgebildet sind, um einen zeitlichen Verlauf einer für den Signalverlauf charakteristischen Feldgröße in einem Abstand von der Energieversorgungsleitung zu detektieren. Darüber hinaus umfasst die Erfassungsvorrichtung ein oder mehrere Schnittstellen, die ausgebildet sind, um Information über den zeitlichen Verlauf der Feldgröße in einem Kommunikationsnetzwerk zu kommunizieren. Schließlich gibt es in der Erfassungsvorrichtung noch ein oder mehrere Signalverarbeitungskomponenten, die ausgebildet sind, um über die ein oder mehreren Sensorelemente den zeitlichen Verlauf der Feldgröße zu erfassen, um Information über den zeitlichen Verlauf der Feldgröße zu generieren und um die Information über den zeitlichen Verlauf der Feldgröße über die ein oder mehreren Schnittstellen in dem Kommunikationsnetzwerk zu kommunizieren. Durch die Erfassung der Feldgrö-ßen, die für den Signalverlauf in der Energieversorgungsleitung charakteristisch ist, ist eine Überwachung auch aus einer gewissen Distanz oder in einem Abstand von der eigentlichen Leitung möglich.

Die ein oder mehreren Sensorelemente können beispielsweise ausgebildet sein, um ein elektrisches Feld oder ein magnetisches Feld der Energieversorgungleitung als Feldgröße zu detektieren. Dabei kann ermöglicht werden, über die elektrische Feldstärke eine Spannung und über die magnetische Feldstärker einen Strom zu überwachen. Die ein oder mehreren Sensorelemente können ausgebildet sein, um die Feldgröße in einem vorbestimmten Abstand an einer freien Energieversorgungsleitung zu detektieren. Dieser vorbestimmte Abstand kann sich zum Beispiel nach der Signalstärke in der Leitung richten. Typischerweise wird mit steigender Signalstärke auch die entsprechende Feldgröße ansteigen, sodass insbesondere auch bei Hochvoltleitungen ein sicherer Abstand eingehalten werden kann.

In Ausführungsbeispielen können die ein oder mehreren Signalverarbeitungskomponenten ausgebildet sein, um die ein oder mehreren zeitlichen Verläufe über die ein oder mehreren Sensorelemente analog zu erfassen und digital zu wandeln, wobei eine Signalabtastung zur digitalen Wandlung mit mehr als 100Hz erfolgt. Dadurch können Signale mit typischen Netzfrequenzen überwacht werden.

Die Erfassungsvorrichtung kann darüber hinaus ausgebildet sein, um eine Mehrzahl von Signalverläufen in einer Mehrzahl von Energieversorgungsleitungen zu erfassen, wobei die ein oder mehreren Sensorelemente ausgebildet sind, um mehrere Feldgrößen zu detektieren, die für die Signalverläufe in den Energieversorgungsleitungen charakteristisch sind. Dabei können ferner die ein oder mehreren Schnittstellen ausgebildet sein, um Information über die zeitlichen Verläufe der mehreren Feldgrößen in dem Kommunikationsnetzwerk zu kommunizieren. Die ein oder mehreren Signalverarbeitungskomponenten sind dann ausgebildet, um über die ein oder mehreren Sensorelemente mehrere zeitliche Verläufe der Feldgrößen zu detektieren, um Information über die zeitlichen Verläufe der Feldgrößen zu generieren und um die Information über die mehreren zeitlichen Verläufe der Feldgrößen über die ein oder mehreren Schnittstellen in dem Kommunikationsnetzwerk zu kommunizieren. Somit können Ausführungsbeispiele auch Mehrleitersysteme überwachen.

Ausführungsbeispiele schaffen darüber hinaus eine Überwachungsvorrichtung zur Überwachung von ein oder mehreren Signalverläufen in ein oder mehreren Energieversorgungsleitungen. Die Überwachungsvorrichtung umfasst ein oder mehrere Schnittstellen, die ausgebildet sind, um Information über ein oder mehrere zeitliche Verläufe von einer oder mehreren Feldgröße/-n über ein Kommunikationsnetzwerk zu erhalten. Darüber hinaus umfasst die Überwachungsvorrichtung ein oder mehrere Signalverarbeitungskomponenten, die ausgebildet sind, um über die ein oder mehreren Schnittstellen, die Information über die ein oder mehreren zeitlichen Verläufe der Feldgrößen zu erhalten. Die ein oder mehreren Signalverarbeitungskomponenten sind ferner ausgebildet, um in den ein oder mehreren zeitlichen Verläufen eine Normabweichung zu detektieren und um eine Information über die Normabweichung zu generieren. Insofern können die zeitlichen Verläufe auch an einer zentralen Stelle ausgewertet werden, zu der sie über ein Kommunikationsnetzwerk übertragen werden. Beispielsweise können so Statusmeldungen oder Warnmeldungen generiert werden.

Die ein oder mehreren Signalverarbeitungskomponenten können darüber hinaus ausgebildet sein, um die Normabweichung durch Vergleich der ein oder mehreren zeitlichen Verläufe der Feldgröße/-n mit statistisch erwarteten zeitlichen Verläufen der Feldgröße/-n zu detektieren.

Ausführungsbeispiele können so eine aufwandsgünstige Analyse ermöglichen, z.B. Korrelationsanalysen.

In weiteren Ausführungsbeispielen können die ein oder mehreren Signalverarbeitungskomponenten auch ausgebildet sein, um bei dem Vergleich Auswirkungen aktueller Umgebungsbedingungen auf die ein oder mehreren zeitlichen Verläufe der Feldgrößen zu berücksichtigen. Insofern kann die Analyse beispielsweise an Tageszeiten, Wochentag, Jahreszeiten, Wetter-/Witterungsanalyse und ähnliches angepasst werden. In manchen Ausführungsbeispielen können die ein oder mehreren Signalverarbeitungskomponenten ausgebildet sein, um über die ein oder mehreren zeitlichen Verläufe der Feldgrößen einen Kurzschluss oder eine Unterbrechung einer Energieversorgungsleitung zu detektieren und eine Information über den Kurzschluss oder die Unterbrechung und dessen/deren Ort zu generieren. Ausführungsbeispiele können so einen effizienten Warn- und/oder Überwachungsmechanismus begünstigen.

Ein weiteres Ausführungsbeispiel ist eine Halterung zur Montage einer Erfassungsvorrichtung gemäß der vorliegenden Beschreibung relativ zu einer Energieversorgungsleitung in einem definierten Abstand. Beispielsweise kann die Halterung an einem Freileitungsmast vorgesehen sein oder als separater Mast ausgelegt sein. Die Halterung kann ausgebildet sein, um die Erfassungsvorrichtung außerhalb einer Schutzzone für die Energieversorgungsleitung zu montieren. Insofern kann die Halterung auch ausgebildet sein, um die Erfassungsvorrichtung weit genug entfernt von einer Freileitung zu montieren, beispielsweise außerhalb einer Schutzzone und gleichzeitig jedoch nahe genug, um die ausreichend aussagekräftige Feldgrößen zu erfassen.

Ausführungsbeispiele schaffen auch ein Energieversorgungssystem mit ein oder mehreren Energieversorgungsleitungen, einer Halterung gemäß der vorliegenden Beschreibung, einer Erfassungsvorrichtung gemäß der vorliegenden Beschreibung und einer Überwachungsvorrichtung gemäß der vorliegenden Beschreibung.

Ein weiteres Ausführungsbeispiel ist ein Erfassungsverfahren zur Erfassung von Information über einen Signalverlauf in einer Energieversorgungsleitung, mit Detektieren eines zeitlichen Verlaufs einer für den Signalverlauf charakteristischen Feldgröße in einem Abstand von der Energieversorgungsleitung und Generieren von Information über den zeitlichen Verlauf der Feldgröße. Das Erfassungsverfahren umfasst ferner ein Kommunizieren der Information über den zeitlichen Verlauf der Feldgröße in einem Kommunikationsnetzwerk.

Ein Überwachungsverfahren zur Überwachung von ein oder mehreren Signalverläufen in ein oder mehreren Energieversorgungsleitungen ist ein weiteres Ausführungsbeispiel. Das Überwachungsverfahren umfasst ein Erhalten von Information über ein oder mehrere zeitliche Verläufe von Feldgrößen über ein Kommunikationsnetzwerk, ein Detektieren einer Normabweichung in den ein oder mehreren zeitlichen Verläufen und ein Generieren einer Information über die Normabweichung.

Ausführungsbeispiele schaffen darüber hinaus ein Computerprogramm mit einem Programmcode zur Durchführung eines der Verfahren gemäß der vorliegenden Beschreibung, wenn der Programmcode auf einem Computer, einem Prozessor oder einer programmierbaren Hardwarekomponente ausgeführt wird.

### Figurenkurzbeschreibung

Einige Beispiele von Vorrichtungen und/oder Verfahren werden nachfolgend bezugnehmend auf die beiliegenden Figuren lediglich beispielhaft näher erläutert. Es zeigen:
Fig. 1 ein Blockdiagramm eines Ausführungsbeispiels einer Erfassungsvorrichtung;
Fig. 2 ein Blockdiagramm eines Ausführungsbeispiels einer Überwachungsvorrichtung;
Fig. 3 ein Ablaufdiagramm eines Ausführungsbeispiels eines Erfassungsverfahrens;
Fig. 4 ein Ablaufdiagramm eines Ausführungsbeispiels eines Überwachungsverfahrens;
Fig. 5 eine schematische Darstellung einer Energieversorgungsleitung;
Fig. 6 eine Illustration einzuhaltender Schutzabstände an einer Mittelspannungsfreileitung;
Fig. 7 eine Darstellung typischer Signalverläufe;
Fig. 8 eine Darstellung möglicher Abstände in einem Ausführungsbeispiel;
Fig. 9 eine Darstellung von Feldgrößen und deren Temperaturabhängigkeit;
Fig. 10 eine Darstellung der Feldstärkenintensität in Abhängigkeit der Entfernung;
Fig. 11 Beispielverläufe der elektrischen Feldstärke und der magnetischen Flussdichte abhängig von der Entfernung;
Fig. 12 Beispiele für Feldstärken statischer und niederfrequenter Felder;
Fig. 13 einen Beispielverlauf der magnetischen Flussdichte;
Fig. 14 einen Beispielverlauf der elektrischen Feldstärke;
Fig. 15 einen zeitlichen Verlauf einer Flussdichte über einen Tag;
Fig. 16 eine Illustration von Überspannungspulsen;
Fig. 17 eine Systemarchitektur in einem Ausführungsbeispiel;
Fig. 18 eine alternative Systemarchitektur in einem Ausführungsbeispiel; und
Fig. 19 eine weitere alternative Systemarchitektur in einem Ausführungsbeispiel.

### Beschreibung

Einige Beispiele werden nun ausführlicher Bezug nehmend auf die beiliegenden Figuren beschrieben. Weitere mögliche Beispiele sind jedoch nicht auf die Merkmale dieser detailliert beschriebenen Ausführungsformen beschränkt. Diese können Modifikationen der Merkmale sowie Entsprechungen und Alternativen zu den Merkmalen aufweisen. Ferner soll die Terminologie, die hierin zum Beschreiben bestimmter Beispiele verwendet wird, nicht einschränkend für weitere mögliche Beispiele sein.

Gleiche oder ähnliche Bezugszeichen beziehen sich in der gesamten Beschreibung der Figuren auf gleiche oder ähnliche Elemente beziehungsweise Merkmale, die jeweils identisch oder auch in abgewandelter Form implementiert sein können, während sie die gleiche oder eine ähnliche Funktion bereitstellen. In den Figuren können ferner die Stärken von Linien, Schichten und/oder Bereichen zur Verdeutlichung übertrieben sein.

Wenn zwei Elemente A und B unter Verwendung eines "oder" kombiniert werden, ist dies so zu verstehen, dass alle möglichen Kombinationen offenbart sind, d. h. nur A, nur B sowie A und B, sofern nicht im Einzelfall ausdrücklich anders definiert. Als alternative Formulierung für die gleichen Kombinationen kann "zumindest eines von A und B" oder "A und/oder B" verwendet werden. Das gilt Äquivalent für Kombinationen von mehr als zwei Elementen.

Wenn eine Singularform, z. B. "ein, eine" und "der, die, das" verwendet wird und die Verwendung nur eines einzelnen Elements weder explizit noch implizit als verpflichtend definiert ist, können weitere Beispiele auch mehrere Elemente verwenden, um die gleiche Funktion zu implementieren. Wenn eine Funktion im Folgenden als unter Verwendung mehrerer Elemente implementiert beschrieben ist, können weitere Beispiele die gleiche Funktion unter Verwendung eines einzelnen Elements oder einer einzelnen Verarbeitungsentität implementieren. Es versteht sich weiterhin, dass die Begriffe "umfasst", "umfassend", "aufweist" und/oder "aufweisend" bei deren Gebrauch das Vorhandensein der angegebenen Merkmale, Ganzzahlen, Schritte, Operationen, Prozesse, Elemente, Komponenten und/oder einer Gruppe derselben beschreiben, dabei aber nicht das Vorhandensein oder das Hinzufügen eines oder mehrerer anderer Merkmale, Ganzzahlen, Schritte, Operationen, Prozesse, Elemente, Komponenten und/einer Gruppe derselben ausschließen.

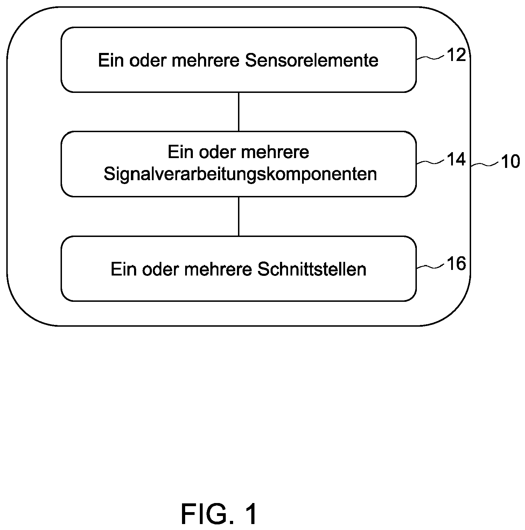

Fig. 1 zeigt ein Blockdiagramm eines Ausführungsbeispiels einer Erfassungsvorrichtung 10, die zur Erfassung von Information über einen Signalverlauf in einer Energieversorgungsleitung ausgebildet ist. Die Erfassungsvorrichtung 10 umfasst ein oder mehreren Sensorelemente 12, die ausgebildet sind, um einen zeitlichen Verlauf einer für den Signalverlauf charakteristischen Feldgröße in einem Abstand von der Energieversorgungsleitung zu detektieren. Die Erfassungsvorrichtung 10 umfasst ferner ein oder mehrere Schnittstellen 16, die ausgebildet sind, um Information über den zeitlichen Verlauf der Feldgröße in einem Kommunikationsnetzwerk zu kommunizieren. Schließlich umfasst die Erfassungsvorrichtung 10 auch noch ein oder mehrere Signalverarbeitungskomponenten 14, die sowohl mit den ein oder mehreren Sensorelementen 12 als auch mit den ein oder mehreren Schnittstellen 16 gekoppelt sind. Die ein oder mehreren Signalverarbeitungskomponenten 14 sind ausgebildet, um über die ein oder mehreren Sensorelemente 12 den zeitlichen Verlauf der Feldgröße zu erfassen, um Information über den zeitlichen Verlauf der Feldgröße zu generieren und um die Information über den zeitlichen Verlauf der Feldgröße über die ein oder mehreren Schnittstellen 16 in dem Kommunikationsnetzwerk zu kommunizieren.

Die ein oder mehreren Sensorelemente 12 können beliebige Sensoren umfassen, die dazu geeignet sind entsprechende Feldgrößen zu erfassen. Beispielsweise sind die ein oder mehreren Sensorelemente 12 ausgebildet, um ein elektrisches Feld oder ein magnetisches Feld der Energieversorgungleitung als Feldgröße zu detektieren. Dabei können eindimensionale und/oder auch mehrdimensionale Sensoren zum Einsatz kommen. Die Feldgrößen, die um eine Energieversorgungsleitung herum messbar sind, sind zumeist richtungsabhängig und können so z.B. als vektorielle Größen erfasst werden. In manchen Ausführungsbeispielen werden nur deren betragsmäßige Verläufe ausgewertet, es sind aber auch Ausführungsbeispiele denkbar, die richtungsspezifische Größen auswerten.

Elektrische Feldsensoren sind Sensoren oder Sensorelemente, die zur Erkennung und Messung elektrischer Felder in verschiedenen Anwendungen eingesetzt werden. Diese Sensoren wandeln die elektrische Feldstärke in ein elektrisches Signal um, das verarbeitet und gemessen werden kann, z.B. eine Spannung, Strom oder auch Widerstand. Sie werden häufig in den Bereichen elektrische Energieverteilung, Luft- und Raumfahrt, Telekommunikation und Umweltüberwachung eingesetzt. Elektrische Feldsensoren spielen eine entscheidende Rolle bei der Gewährleistung der Sicherheit und Effizienz elektrischer Systeme, indem sie Echtzeitdaten über elektrische Feldstärken liefern und Betreibern helfen, potenzielle Probleme oder Fehlfunktionen zu erkennen. Diese Sensoren sind so konzipiert, dass sie empfindlich, genau und zuverlässig sind, was sie zu Werkzeugen für die Verbesserung der Leistung und Zuverlässigkeit elektrischer Systeme macht. So können solche Sensoren zur Erfassung des elektrischen Feldes einer Energieversorgungsleitung auch in einem Abstand zur Leitung eingesetzt werden.

Magnetfeldsensoren sind Sensoren oder Sensorelemente zur Messung und Erkennung von Magnetfeldern. Diese Sensoren werden in einer Vielzahl von Anwendungen eingesetzt, unter anderem in der Automobil-, Industrie- und Unterhaltungselektronik. Sie funktionieren, indem sie Änderungen in Magnetfeldern erkennen und diese in elektrische Signale umwandeln (Spannung/Strom/Widerstand), die verarbeitet und analysiert werden können. Beispiele für Magnetfeldsensoren sind Hall-Effekt-Sensoren, magnetoresistive Sensoren, Fluxgate-Sensoren und magnetostriktive Sensoren. Diese Sensoren werden in zahlreichen Anwendungen wie Kompassen, Navigationssystemen, Näherungsschaltern und Stromsensoren eingesetzt. Ihre teilweise hohe Empfindlichkeit und Genauigkeit machen sie zu Hilfsmitteln in der modernen Technik. Auch sie können demnach in einem Abstand zur einer Energieversorgungsleitung eingesetzt werden, um das magnetische Feld zu messen oder zu erfassen.

In Ausführungsbeispielen können die eine oder mehreren Schnittstellen 16 jedem Mittel zum Erhalten, Empfangen, Übertragen oder Bereitstellen von analogen oder digitalen Signalen oder Informationen entsprechen, z. B. jedem Stecker, Kontakt, Stift, Register, Eingangsanschluss, Ausgangsanschluss, Leiter, Spur usw., der die Bereitstellung eines Signals ermöglicht. Eine Schnittstelle kann drahtlos oder drahtgebunden sein, und sie kann so konfiguriert sein, dass sie mit weiteren internen oder externen Komponenten kommuniziert, d. h. Signale oder Informationen überträgt oder empfängt. Vorliegend können die ein oder mehrere Schnittstellen beispielsweise ausgebildet sein, um Information über die erfassten Feldgrößen zumindest in Teilen schnurlos and eine Zentralstelle, wie z.B. eine Überwachungsvorrichtung wie nachfolgend beschrieben wird, zu übertragen. Dabei können diese auch von Mobilfunknetzten oder anderen Drahtlosnetzzugängen Gebrauch machen und entsprechende Senderkomponenten, Empfängerkomponenten, Gateways, usw. umfassen.

Das Mobilkommunikationssystem kann beispielsweise einem der von der 3rd Generation Partnership Project (3GPP) standardisierten Mobilkommunikationssysteme entsprechen, wie Global System for Mobile Communications (GSM), Enhanced Data rates for GSM Evolution (EDGE), GSM EDGE Radio Access Network (GERAN), High Speed Packet Access (HSPA), Universal Terrestrial Radio Access Network (UTRAN) oder Evolved UTRAN (E-UTRAN), Long Term Evolution (LTE) oder LTE-Advanced (LTE-A), 5G (5^{th} Generation), 6G (6^{th} Generation) oder Mobilkommunikationssysteme mit anderen Standards, z. B. z. B. Worldwide Interoperability for Microwave Access (WIMAX) IEEE 802.16 oder Wireless Local Area Network (WLAN) IEEE 802.11, allgemein jedes System, das auf Time Division Multiple Access (TDMA), Frequency Division Multiple Access (FDMA), Orthogonal Frequency Division Multiple Access (OFDMA), Code Division Multiple Access (CDMA) usw. basiert. Im Folgenden werden die Begriffe Mobilkommunikationssystem und Mobilkommunikationsnetz synonym verwendet. Dabei kommt es in Ausführungsbeispielen nicht auch eine konkrete Implementierung des Zugangs an, sondern vielmehr darauf, dass von der Erfassungsvorrichtung 10 erfasste Daten über die Feldgrößen an eine entsprechende Überwachungsvorrichtung weitergeleitet werden. Dies wäre auch schnurgebunden denkbar.

In Ausführungsbeispielen können die ein oder mehreren Signalverarbeitungskomponenten 14 zur digitalen Signalverarbeitung ausgebildet sein. Dabei können sie als eine oder mehrere Verarbeitungseinheiten, ein oder mehrere Verarbeitungsgeräte, ein beliebiges Mittel zur Verarbeitung, ein beliebiges Mittel zur Bestimmung, ein beliebiges Mittel zur Berechnung, wie einem Prozessor, einem Computer oder einer programmierbaren Hardwarekomponente, die mit entsprechend angepasster Software betrieben werden kann, implementiert werden. Beispielsweise können die ein oder mehreren Signalverarbeitungskomponenten auch Wandler oder Konverter umfassen, um analoge Signal in Digitalsignale zu wandeln. Die beschriebene Funktion der ein oder mehreren Signalverarbeitungskomponenten 14 kann auch in Software implementiert sein, die dann auf einer oder mehreren programmierbaren Hardwarekomponenten ausgeführt wird. Solche Hardwarekomponenten können einen Universalprozessor, einen digitalen Signalprozessor (DSP), einen Mikrocontroller usw. umfassen.

Die ein oder mehreren Sensorelemente 12 sind dabei ausgebildet, um die Feldgröße in einem vorbestimmten Abstand an einer freien Energieversorgungsleitung zu detektieren. Dementsprechend werden die ein oder mehreren Sensorelemente so gewählt, dass deren Empfindlichkeit in dem Abstand noch hoch genug ist, um das entsprechende sinnvoll Feld zu erfassen. Entsprechend sollen auch etwaige Störgrößen in dem besagten Abstand eine sinnvolle Auswertung noch ermöglichen. Im Folgenden wird anhand der beigefügten Figuren noch erläutert, wie sich die Felder unter realistischen Umgebungsbedingungen und Abständen verhalten und wie die Sensoren zur Erfassung ausgelegt werden.

Die Erfassungsvorrichtung 10 kann dabei auch ausgebildet sein, um eine Mehrzahl von Signalverläufen in einer Mehrzahl von Energieversorgungsleitungen zu erfassen. Dies kommt bei Mehrleitersystemen, wie sie beispielsweise bei Drehstromsystemen verwendet werden, infrage, sodass die Leiter auch einzelnen überwacht werden können. Die ein oder mehreren Sensorelemente 12 sind dann ausgebildet, um mehrere Feldgrößen zu detektieren, die für die Signalverläufe in den Energieversorgungsleitungen charakteristisch sind. Analog kann dann über die ein oder mehreren Schnittstellen 16 Information über die zeitlichen Verläufe der mehreren Feldgrößen in dem Kommunikationsnetzwerk kommuniziert werden. Die ein oder mehreren Signalverarbeitungskomponenten 14 sind dann ausgebildet, um über die ein oder mehreren Sensorelemente 12 die mehreren zeitlichen Verläufe der Feldgrößen zu detektieren, um Information über die zeitlichen Verläufe der Feldgrößen zu generieren und um die Information über die mehreren zeitlichen Verläufe der Feldgrößen über die ein oder mehreren Schnittstellen in dem Kommunikationsnetzwerk zu kommunizieren.

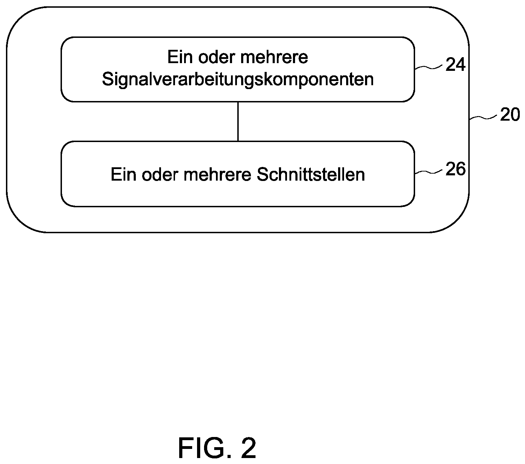

Fig. 2 zeigt ein Blockdiagramm eines Ausführungsbeispiels einer Überwachungsvorrichtung 20. Die Überwachungsvorrichtung 20 bildet quasi das Gegenstück zur Erfassungsvorrichtung 10 und erhält von dieser, ggf. auch von einer Vielzahl von Erfassungsvorrichtungen 10, entsprechende Information über die erfassten Feldgrößen. Wie die Fig. 2 zeigt, umfasst auch die Überwachungsvorrichtung 20 zur Überwachung von ein oder mehreren Signalverläufen in ein oder mehreren Energieversorgungsleitungen ein oder mehrere Schnittstellen 26, die ausgebildet sind, um Information über ein oder mehrere zeitliche Verläufe von Feldgröße/-n über ein Kommunikationsnetzwerk zu erhalten. Die ein oder mehreren Schnittstellen 26 sind dabei analog zu den oben beschriebenen Schnittstellen 16 ausgebildet und mit ein oder mehreren Signalverarbeitungskomponenten 24 gekoppelt. Die ein oder mehreren Signalverarbeitungskomponenten 24 sind analog zu den oben beschriebenen Signalverarbeitungskomponenten 14 ausgebildet oder implementiert. Die ein oder mehreren Signalverarbeitungskomponenten 24 sind ausgebildet, um über die ein oder mehreren Schnittstellen 26, die Information über die ein oder mehreren zeitlichen Verläufe der Feldgrößen zu erhalten. Die ein oder mehreren Signalverarbeitungskomponenten 24 sind ferner ausgebildet, um in den ein oder mehreren zeitlichen Verläufen eine Normabweichung zu detektieren und um eine Information über die Normabweichung zu generieren.

Beispielsweise kann die Normabweichung durch Vergleich der ein oder mehreren zeitlichen Verläufe der Feldgröße/-n mit statistisch erwarteten zeitlichen Verläufen der Feldgröße/-n detektiert werden. Z.B kann eine Korrelationsanalyse mit vorbekannten Verläufen durchgeführt werden, um bestimmte Betriebszustände oder auch Fehlfunktionen zu detektieren. Dabei können die ein oder mehreren Signalverarbeitungskomponenten 24 auch ausgebildet sein, um bei dem Vergleich Auswirkungen aktueller Umgebungsbedingungen auf die ein oder mehreren zeitlichen Verläufe der Feldgrößen zu berücksichtigen. Dazu werden anhand der nachfolgenden Figuren noch Effekte der Temperatur und der Tageszeit näher erläutert. In Ausführungsbeispielen können aber beliebige statistische Informationen, wie z.B. über Wochentag, Jahreszeit, Wetter, usw. bei dem Vergleich berücksichtigt werden. Es kann auch eine künstliche Intelligenz über die ein oder mehreren Signalverarbeitungskomponenten 24 der Überwachungsvorrichtung 20 implementiert werden, die mit entsprechenden statistischen Daten oder bekannten Verläufen trainiert wird und anschließend aktuelle Verläufe dahingehend klassifiziert, ob eine Normabweichung vorliegt oder nicht. In manchen Ausführungsbeispielen ist es auch denkbar ein neuronales Netz mit solchen Daten zu trainieren und im laufenden Betrieb weiter zu trainieren, sodass stetige Anpassungen erfolgen. Dies kann insbesondere in Bezug auf Fehlalarme oder hinsichtlich nicht detektierter Ereignisse vorteilhalft sein.

Beispielsweise können aus den ein oder mehreren zeitlichen Verläufen der Feldgrößen ein Kurzschluss oder eine Unterbrechung einer Energieversorgungsleitung detektiert werden und eine Information über den Kurzschluss oder die Unterbrechung und dessen/deren Ort zu generieren. Auf diese Weise können Statusmeldungen, Fehlermeldungen oder auch Warnmeldungen generiert werden.

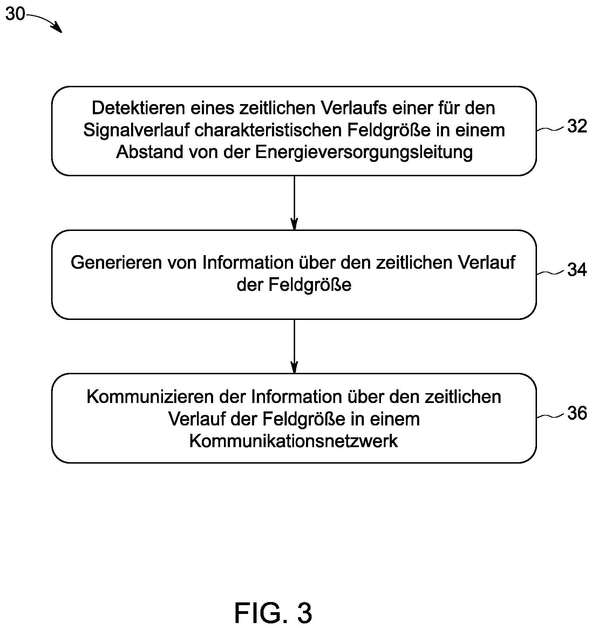

Fig. 3 zeigt ein Ablaufdiagramm eines Ausführungsbeispiels eines Erfassungsverfahrens 30 zur Erfassung von Information über einen Signalverlauf in einer Energieversorgungsleitung. Das Verfahren 30 umfasst ein Detektieren 32 eines zeitlichen Verlaufs einer für den Signalverlauf charakteristischen Feldgröße in einem Abstand von der Energieversorgungsleitung. Das Verfahren 30 umfasst ferner ein Generieren 34 von Information über den zeitlichen Verlauf der Feldgröße und ein Kommunizieren 36 der Information über den zeitlichen Verlauf der Feldgröße in einem Kommunikationsnetzwerk.

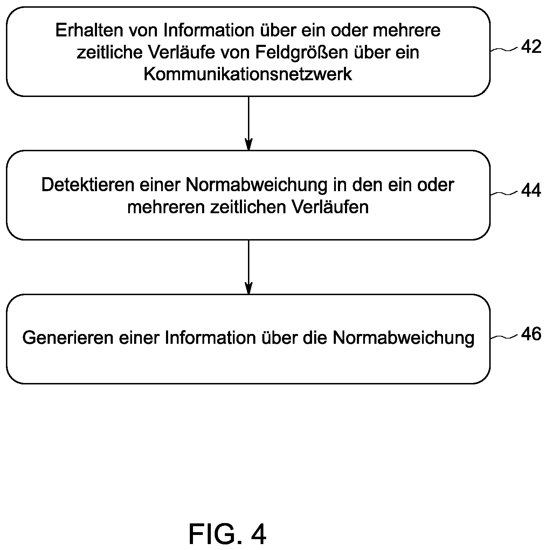

Fig. 4 zeigt ein Ablaufdiagramm eines Ausführungsbeispiels eines Überwachungsverfahrens 40 zur Überwachung von ein oder mehreren Signalverläufen in ein oder mehreren Energieversorgungsleitungen. Das Verfahren 40 umfasst ein Erhalten 42 von Information über ein oder mehrere zeitliche Verläufe von Feldgrößen über ein Kommunikationsnetzwerk und ein Detektieren 44 einer Normabweichung in den ein oder mehreren zeitlichen Verläufen. Das Verfahren 40 umfasst ferner ein Generieren 46 einer Information über die Normabweichung.

Ein weiteres Ausführungsbeispiel ist ein Computerprogramm mit einem Programmcode zur Durchführung eines der hierin beschriebenen Verfahren, wenn der Programmcode auf einem Computer, einem Prozessor oder einer programmierbaren Hardwarekomponente ausgeführt wird.

Ausführungsbeispiele können so ein autarkes Gerät oder eine Erfassungsvorrichtung 10 bereitstellen (Sensor, Montagehalterung und IoT-Gateway), das/die einfach zu montieren ist, das/die zuverlässig aus sicherem Abstand (3-4 Meter) den Ausfall einer oder mehreren Phasen erkennen kann und im Bedarfsfall Orts- und Zustandsinformationen an eine Leitstelle (Überwachungsvorrichtung 20) übermittelt und damit zur Netzstabilität beitragen kann. Die hier vorgestellten Vorrichtungen 10, 20 und Verfahren 30, 40 funktionieren theoretisch für elektrische Felder und magnetische Felder. Der Unterschied besteht einzig in der Auswahl der "Meßsonde" (der ein oder mehreren Sensorelemente 12).

In der Praxis sollen Spannungseinbrüche (z.B. Kurzschluss) in der Versorgung vermieden werden, da diese den Effektivwert der elektrischen Spannung für einen kurzen Zeitraum vermindern. Der Spannungseinbruch kann einige Millisekunden bis Minuten betragen. Dieser Spannungseinbruch im zeitlichen Verlauf kann mit Hilfe der vorliegenden Ausführungsbeispiele zuverlässig erkannt werden.

Beispielsweise wird die Änderung der Feldstärke dabei permanent als "3D-Muster" (quasi zeitlicher Fingerabdruck) lokal an der Freileitung mit dem Sensor erfasst, zwischengespeichert und zu einer KI (Künstliche Intelligenz in der Überwachungsvorrichtung 20) zur Analyse übertragen, die beispielsweise in einem Edge-Server mit KI oder einer zentralen KI implementiert sein kann. Mit Hilfe statistischer Methoden werden der ortsübliche Normwert und dessen normale Streuung in einer zentralen KI ermittelt bzw. erlernt und regelmäßig als zu erwartender "Sollwert" (Prognose) dem lokalen Gerät zur Verfügung gestellt. Spannungsänderungen, beispielsweise hervorgerufen durch einen Kurzschluss, führen zu einer kurzfristigen Änderung an der Messsonde. Diese Abweichung wird lokal ermittelt und der Fehlerort und die Werte in eine Leitstelle (Überwachungsvorrichtung 20) übertragen.

Die Nutzung eines 5G-Netzwerkes zum Datentransport hat den Vorteil, dass in Echtzeit große Datenmengen übertragen werden könnten. Zudem hätte der Einsatz von Network-SLICING und Edge-Computing Vorteile im Betrieb in Bezug auf Security (Networkslice, Sicherheit) Resilienz und Quality of Service (Servicequalität).

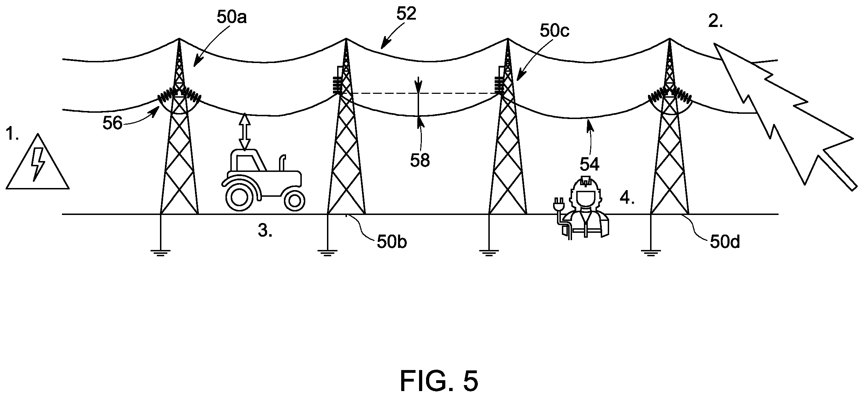

Fig. 5 zeigt eine schematische Darstellung einer Energieversorgungsleitung.
Quelle: https://www.enargus.de/pub/bscw.cgi/d4001-2/*/*/Freileitung?op=Wiki.getwiki&se-arch=drehstrom&scope=all
Fig. 5 illustriert eine Anordnung von vier Masten (Abspannmaste 50a, 50d, und Tragmaste 50b, 50c), die ein Erdungsseil (Erdseil) 52 und einen Stromleiter 54 tragen. Der Stromleiter 54 ist durch Isolatoren 56 vom jeweiligen Mast isoliert. Die Fig. 5 zeigt darüber hinaus den von weiteren Parametern wie der mechanischen Seilspannung abhängigen Durchhang 58 des Stromleiters 54. Die Freileitung ist ein Beispiel für eine Energieversorgungsleitung.

Eine Freileitung, auch als Überlandleitung bezeichnet, ist eine elektrische Leitung, bei der die einzelnen Leiterseile nur durch die dazwischen liegende Luft voneinander und gegen Erde isoliert sind. Freileitungen werden fast ausschließlich bei regionalen und überregionalen Übertragungsleitungen im Hochspannungsnetz und Höchstspannungsnetz eingesetzt. Im Gegenzug hierzu werden in Verteilnetzen meist Erdkabel verwendet. Eine Ausnahme besteht für ländliche Gegenden, in denen Freileitungen auch noch im Mittelspannungsnetz zur Anwendung kommen. Die Fig. 5 zeigt Ursachen für Kurzschlüsse, diese sind z.B.:
1. Versagen von Isolierungen,
2. umgefallene Bäume,
3. Lichtbogenentladungen zwischen Leitungen und nah stehenden Objekten, und
4. Menschliches Versagen.

Energieversorger haben daher generell ein Interesse daran zu erfahren, wo ein Kurzschluss im Versorgungsnetz erfolgt.

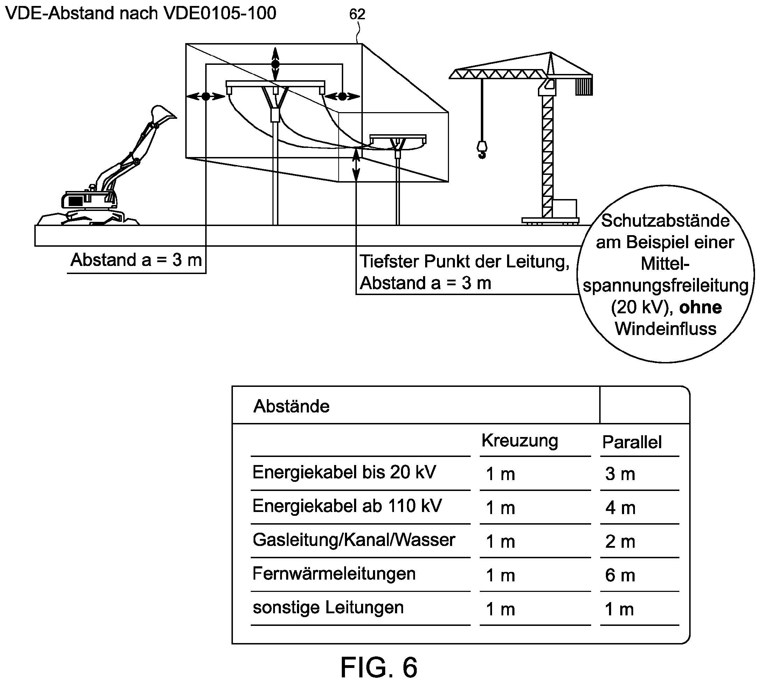

Fig. 6 ist eine Illustration einzuhaltender Schutzabstände an einer Mittelspannungsfreileitung. Quelle: https://www.sh-netz.com/content/dam/revu-global/sh-netz/Documents/EnergieService/Informationen/SH%20Netz%20110%20kV%20Leitungsschutzpdf
Bei Annäherung an den Schutzbereich, der in der Fig. 6 als kubischer Korridor 62 angegeben ist, sind besondere Maßnahmen erforderlich. Die Schutzabstände sind am Beispiel einer Mittelspannungsfreileitung (20 kV), ohne Windeinfluss angegeben. So ist ein Abstand von a >0 3m rund um die Leitung einzuhalten.

Das Ausschwingen von Lasten ist zu beachten. Das Ausschwingen der Leiterseile durch Windeinfluss ist zusätzlich zu berücksichtigen. Bei Unterschreitung des Schutzabstands besteht Lebensgefahr. Bei Leitungsverlegungen anderer Versorgungsträger sind die in der Tabelle in Fig. 6 unten angegebenen Abstände einzuhalten. In Ausführungsbeispielen kann die Installation eines Sensors daher außerhalb der Schutzzone liegen, was eine sichere Wartung, insbesondere eine Wartung, ohne dass der Leiter spannungsfrei geschaltet wird, ermöglichen kann. Der Sensor (eine oder mehrere Sensorelemente 12) muss dafür ausreichend empfindlich sein. Es ergibt sich somit eine Art Korridor für den Abstand eines Sensorelementes zu einem Leiter. Dieser Korridor wird einerseits durch die Schutzzone begrenzt und andererseits durch die Feldstärke und die Empfindlichkeit des Sensors, die einen maximalen Abstand zur technisch sinnvollen Überwachung vorgeben. So sollte die Feldgröße vom Sensor noch erfassbar sein und gegenüber etwaigen Störgrößen noch deutlich hervortreten.

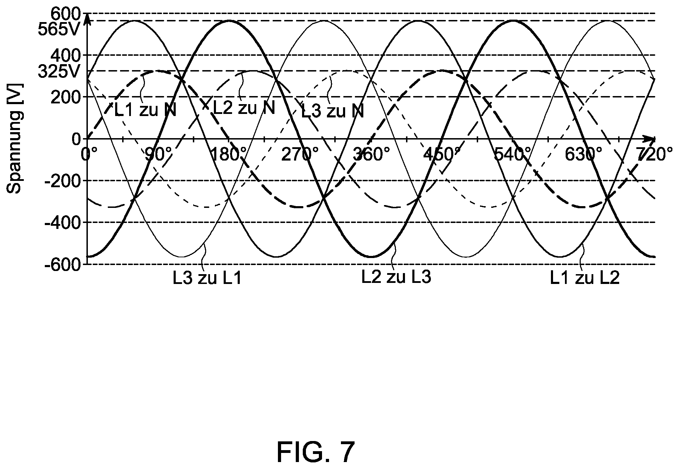

Fig. 7 zeigt eine Darstellung typischer Signalverläufe.
Quelle: https://www.emfethz.ch/de/emf-info/themen/technik/stromversorgung/dreiphasenwechselstrom
Dabei werden in einem Dreileitersystem L1, L2, L3 die Spannungsverläufe zum Neutralleiter (gestrichelte Linien) und die Spannungsverläufe der Phasen untereinander (durchgezogene Linien) gegenüber dem Phasenwinkel der Phase des L1-Signals gezeigt. Umspannwerke speisen die Transformatoren, die den Strom von der Hochspannungsebene (110 kV) in Mittelspannungsnetze umsetzen. Im Mittelspannungsbereich werden üblicherweise in Deutschland Spannungen von 10 kV, 20 kV und 30 kV verwendet. Mittelspannungsnetze arbeiten mit einen sogenannten 3 phasigen Drehstrom, der dann in Trafostationen auf den üblichen 400V für den Gebrauch in Haushalten und Betrieben umgesetzt wird. Die Abbildung in der Fig. 7 zeigt den symmetrischen Zustand.

Energieversorger bemühen sich das Versorgungnetz stabil zu halten und immer symmetrisch zu betreiben. Die übertragene Gesamtleistung sollte bei sinusförmigem Drehstrom immer konstant bleiben, wie die Fig. 7 zeigt.

Fällt eine Phase (L) aus (Kurzschluss) entsteht eine Unsymmetrie im Versorgungsnetz, die vermieden werden soll. Der Unsymmetriegrad im stationären Betrieb sollte für alle Verbrauchen immer <2% liegen. Unsymmetrie führen u.a. zu höheren Verlusten, erhöhten Strom- und Thermischen-Belastungen und Oberschwingungen bei Verbrauchern. Es ist daher wünschenswert, dass ein Ort der Unsymmetrie (Kurzschluss) schnell ermittelt werden kann, um mögliche Schäden zu reduzieren. Dies können Ausführungsbeispiele mit der Erfassungseinrichtung 10 und der Überwachungseinrichtung 20 leisten.

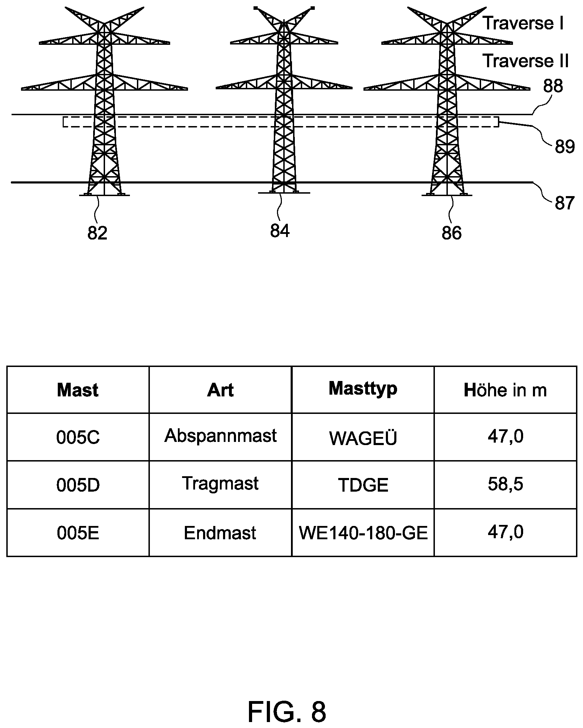

Fig. 8 zeigt eine Darstellung möglicher Abstände in einem Ausführungsbeispiel.
Quelle: https://rp.baden-wuerttemberg.de/fileadmin/RP-Internet/Stuttgart/Abteilung_2/Referat_24/_DocumentLibraries/Planfeststellungsverfahren/Umspannwerk_Grossgartach_planfestgest/24_pfv_UW_grossgartach_01_E-Bericht.pdf
Die Fig. 8 zeigt oben eine Abbildung mir einem Abspannmast 82, einem Tragmast 84 und einem Endmast 86. Etwa 1m über dem Boden lassen sich in dieser Konstellation noch ca. 5-20µ Tesla messen. Bei einer 380kV Leitung wären hier anstelle 20 µ Tesla magnetischer Flussdichte der vierfache Wert ca. 80 µTesla zu erwarten und bei der Messung des elektrischen Feldes wäre ein Wert 12 kV/m zu erwarten. Der Schutzabstand 88 und der Installationsraum 89 für Sensoren etwa 5m unterhalb der Leiter sind ebenfalls angegeben. Der Installationsraum 89 definiert in diesem Ausführungsbeispiel einen Korridor zur Montage der Sensorelemente, der zur Leitung hin durch den Schutzabstand 88 begrenzt ist und nach unten durch die Feldstärke, bzw. auch durch eine Vandalismus-sichere Höhe begrenzt ist.

Die Fig. 8 zeigt in der Tabelle unten die Mastbezeichnungen, Typen und Masthöhen. Daraus ergibt sich, dass auch bei einer Installation des Sensors am Mast unterhalb des Schutzabstandes, eine ausreichend große Feldstärke vorliegt.

Für die im Folgenden beschriebenen Verfahren in Ausführungsbeispielen werden folgende Annahmen getroffen.
- Die Messung der Feldstärke erfolgt dauerhaft im Millisekunden-Bereich. Gemäß dem Nyquist-Shannon-Theorem erfolgt die Abtastung mit einer Frequenz >100 Hz pro Sensor, um Änderungen bei 50 Hz zu erfassen. Bei der entsprechend ausgelegter Erfassungsvorrichtung 10, sind die ein oder mehreren Signalverarbeitungskomponenten 14 dann ausgebildet, um die ein oder mehreren zeitlichen Verläufe über die ein oder mehreren Sensorelemente 12 analog zu erfassen und digital zu wandeln, wobei eine Signalabtastung zur digitalen Wandlung mit mehr als 100Hz erfolgt. Dabei kann ein entsprechend ausgelegter Analog-Digital-Wandler zum Einsatz kommen.
- Umweltbedingungen (Temperatur, Wind) haben in diesen kurzen Zeitintervallen (< 10 min) einen vernachlässigbaren Einfluss und es werden homogene Verhältnisse vorausgesetzt.
- In der Nähe stehende Masten, Gebäude etc. haben immer den gleichen Einfluss (Fehler) auf die Messung und können daher vernachlässigt werden.
- Wird der Sensor (Erfassungsvorrichtung 10) am Freileitungsmast unterhalb der Schutzzone mit geringem Abstand zu der Freileitung installiert, ist im Betrieb ausreichend Feldstärke für die Messung vorhanden, um Unsicherheiten (Toleranzen und Temperaturabhängigkeiten des Sensors) vernachlässigen zu können.
- Sensoren unterliegen einer Alterung. Damit ändern sich die tatsächlich gemessenen Werte im Laufe der Zeit relativ zum ursprünglichen Wert. Dieser Effekt könnte zu Fehlinterpretationen führen und theoretisch müssten die Sensoren regelmäßig überprüft werden. Mit Hilfe einer Mustererkennung (KI) können diese Effekte aus historischen Daten ermittelt und in der Darstellung und im Betrieb berücksichtigt werden. Gegebenenfalls können über Geräte-Parameter-Updates diese Änderungen berücksichtigt werden. Die ein oder mehreren Signalverarbeitungskomponenten 14, 24 können demnach zur Kompensation der Alterungseffekte ausgebildet sein.

Ausführungsbeispiele schaffen darüber hinaus eine Halterung zur Montage einer Erfassungsvorrichtung 10 gemäß der vorliegenden Beschreibung relativ zu einer Energieversorgungsleitung in einem definierten Abstand. Die Halterung kann ausgebildet sein, um die Erfassungsvorrichtung 10 außerhalb einer Schutzzone 88 für die Energieversorgungsleitung zu montieren. In der Fig. 8 ist der Bereich 89 angedeutet, der außerhalb der Schutzzone liegt und nahe genug an den Leitungen, um eine ausreichende Feldstärke zu erfassen. Insbesondere bei Hoch- und Mittelspannungsleitungen ist der Bereich der erfassbaren signifikanten Feldgrößen wesentlich größer als die Schutzzone. In Ausführungsbeispielen kann die Halterung auch direkt an einem Mast vorgesehen sein. Insofern ist ein Mast mit einer solchen Halterung ebenfalls ein Ausführungsbeispiel.

Im Folgenden werden einige physikalische Grundlagen näher erläutert.

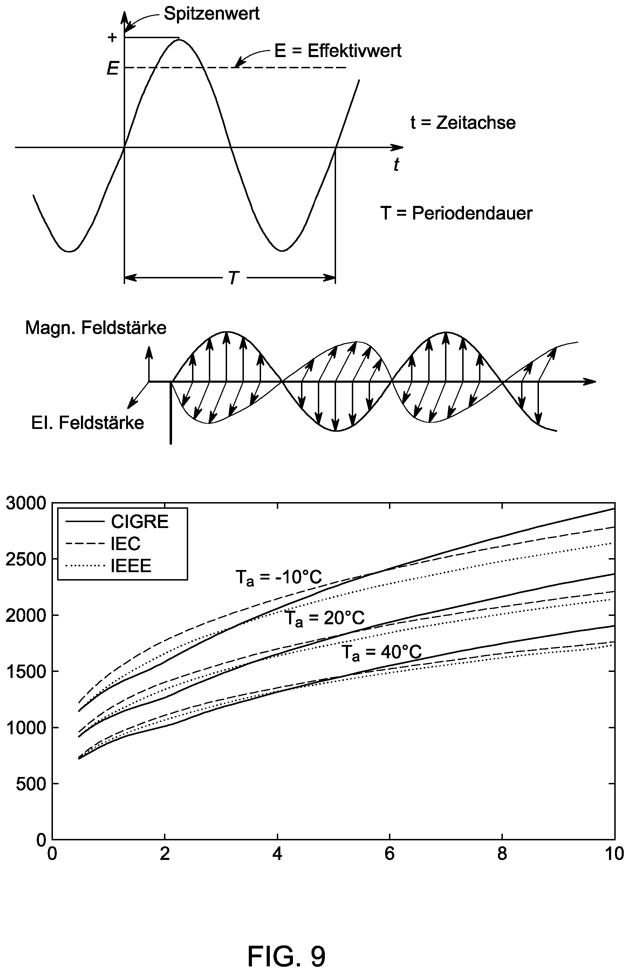

Fig. 9 zeigt eine Darstellung von Feldgrößen und deren Temperaturabhängigkeit.
Quelle: Leitfaden Elektromagentische Felder https://www.fs-ev.org/arbeitskreise/nichtionisierende-strahlung/
Die Fig. 9 zeigt zunächst oben einen typischen Signalverlauf über der Zeit t, mit Spitzenwert Ê, Effektivwert E und Periodendauer T. Ändern sich Strom und Spannung zeitlich, so schlagen sich die Änderungen in den Feldern nieder. Die Abbildung oben zeigt den zeitlichen Verlauf der elektrischen Feldstärke, die durch eine sinusförmige Wechselspannung verursacht wird. In der Mitte zeigt die Fig. 9 die um 90° Grad versetzten Verläufen der Feldvektoren der magnetischen und elektrischen Feldstärken.

Unten zeigt die Fig. 9 typische Stromkapazitäten (maximale Stromkapazität in A) gegenüber der Windgeschwindigkeit in m/s.
Quelle:
7046-ELEKTRIZITAET_Vogel_25.03.2013_ET-Elektrotechnik_Stromtransport_BFEon-line.pdf
Dabei werden die Verläufe nach CIGRE (franz. Internationaler Rat für große elektrische Netze), IEC (International Electrotechnical Commission) und IEEE (Institute of Electrical and Electronics Engineers) für verschiedene Lufttemperaturen (Ta=-10°C, 20°C, 40°C) angegeben.

Die Grafik zeigt, wie stark die Lufttemperatur die Durchleitungskapazität einer Freileitung beeinflusst. Die unteren Kurven veranschaulichen diesen Einfluss für den Sommer: Beträgt die Lufttemperatur nicht 40 °C, sondern -10°C, könnte die Leitung ca. 50% mehr Strom transportieren, ohne zu überhitzen. Bläst der Wind, steigt die Durchleitungskapazität ebenfalls markant an. In der Realität sind nicht nur die Leitungen für die Durchleitungskapazität verantwortlich; daher handelt es sich um theoretische Werte. Die elektrischen und magnetischen Felder werden in Energienetzen (Frequenz <50 Hz) als voneinander entkoppelt betrachtet. Umweltbedingungen haben einen erheblichen Einfluss auf die transprotierbare Energiemenge. Daher werden die Umweltbedingungen zumindest in manchen Ausführungsbeispielen entsprechend bei der Überwachung der Feldgrößen berücksichtigt.

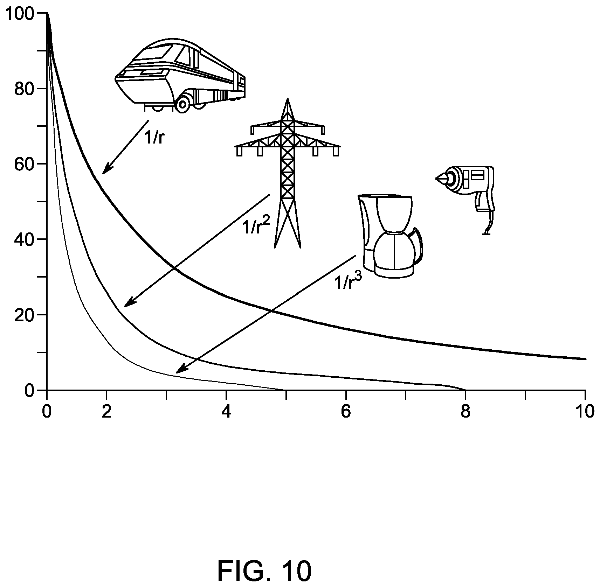

Fig. 10 zeigt eine Darstellung der Feldstärkenintensität in Abhängigkeit der Entfernung.
Quelle: https://www.fs-ev.org/arbeitskreise/nichtionisierende-strahlung/
Die Fig. 10 zeigt die Feldstärkeintensität in % gegenüber der Entfernung r in relativen Einheiten. Die physikalischen Grundlagen sind im Leitfaden "Elektromagentische Felder" des Fachverbands für Strahlenschutz beschrieben, s.o.

Zitat:
Im gesamten Niederfrequenzbereich, aber insbesondere bei den in der elektrischen Energieversorgung eingesetzten Frequenzen, sind elektrische und magnetische Felder weitestgehend entkoppelt, so dass jede Feldkomponente getrennt gemessen/berechnet und bewertet werden kann. Dabei ist das elektrische Feld mit der Spannung und das magnetische Feld mit dem Strom verknüpft. Die Feldstärken verhalten sich je nach Art der Quelle mindestens umgekehrt proportional zum Abstand (linienhafter Leiter z.B. Bahnstromleitung), umgekehrt proportional zum Quadrat des Abstandes (bei Mehrleitersystemen, Überlagerung von hin- und rückfließendem Strom) und umgekehrt proportional zur dritten Potenz des Abstands - z. B. bei Spulen (Werkzeuge, Heizspulen, usw.).

Die Fig. 10 zeigt ein
1/r- Feld eines geraden langen stromdurchflossenen Leiters (z. B. Bahnstromleitung),
1/r²-Feld durch Überlagerung zweier Leiter mit hin- und rückfließendem Strom, und
1/r³⁻Feld einer Zylinderspule (z. B. Elektromotor).

Mit einem geeigneten Sensor kann sowohl das elektrische Feld und oder das magnetische Feld gemessen werden. Bei Freileitungen nimmt die Feldstärke umgekehrt proportional zum Quadrat des Abstands ab. Eine Halbierung der Entfernung führt daher in diesem Anwendungsfall zu einer Vervierfachung der gemessen Werte.

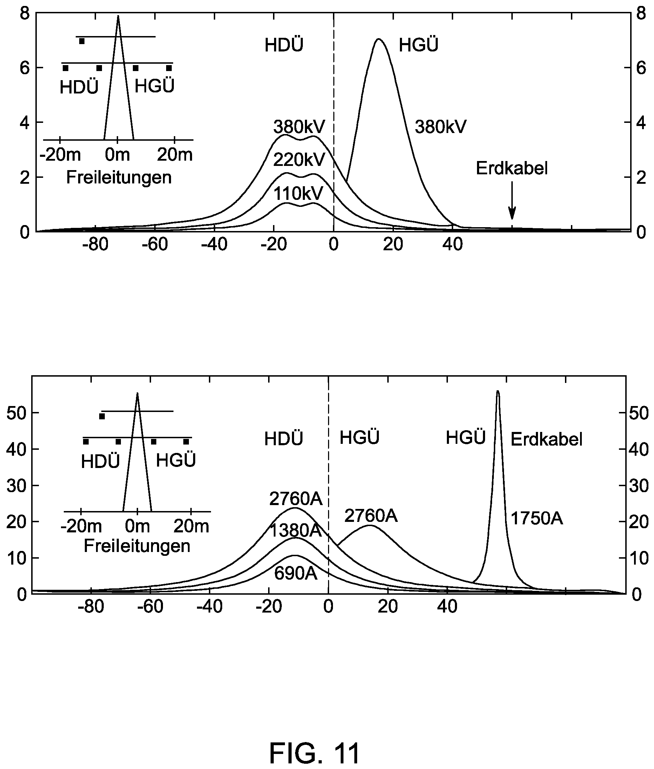

Fig. 11 zeigt Beispielverläufe der elektrischen Feldstärke und der magnetischen Flussdichte abhängig von der Entfernung.
Quelle: https://www.fs-ev.org/fileadmin/user_upload/93_Oeff.-Arbeit/StrahlenschutzKompakt/SK13_Final_Einzelaus13_Kompakt_FSeV_01-2021_HigRes_V2.pdf
Die Fig. 11 zeigt oben einen Verlauf der elektrischen Feldstärke in kV/m in Abhängigkeit des Abstandes von der Trassenmitte in m. Die Fig.11 zeigt unten den Verlauf der magnetischen Flussdichte in µT in Abhängigkeit des Abstandes von der Trassenmitte in m. Die beiden Abbildungen zeigen den Zusammenhang zwischen der elektrischen Feldstärke und der magnetischen Flussdichte in Abhängigkeit der Entfernungsmitte der Trasse. HDÜ steht für Hochspannungs-Drehstrom-Übertragung (von Mast-Mitte links) und HGÜ für Hochspannungs-Gleichstrom-Übertragung (von Mast-Mitte rechts). In Bodennähe sind je nach Typ (110 kV, 220 kV, 380 kV) Flussdichten von 10 µTesla und mehr zu erwarten. Für ein robustes System sollte daher der Sensor (Sensorelemente 12) in der oberen Masthälfte unterhalb des Schutzabstands installiert werden, um ausreichend hohe Werte für die elektrische Feldstärke bzw. die magnetische Flussdichte zu erhalten. Die Sensoren der Messmittel im Allgemeinen haben je nach Qualität eine vordefinierte Empfindlichkeit. Ist der Sensor zu unempfindlich, werden kleine Änderungen nicht erkannt, was zu Problemen im Betrieb (Fehlalarmen) führen könnte.

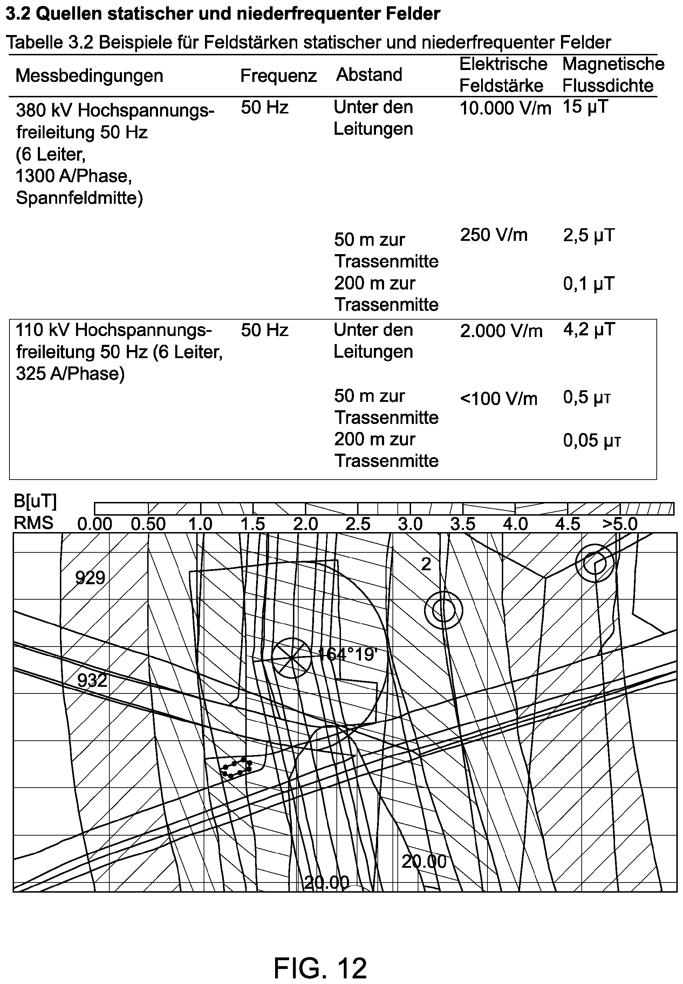

Fig. 12 zeigt Beispiele für Feldstärken statischer und niederfrequenter Felder. Zunächst gibt die Tabelle in der Fig. 12 oben eine Übersicht über Quellen statischer und niederfrequenter Felder (Quelle: https://www.fs-ev.org/arbeitskreise/nichtionisierende-strahlung/)-

Die Darstellung in der Fig. 12 unten zeigt einen typischen Feldverlauf einer magnetischen Flussdichte B in µT einem Kartenausschnitt entlang einer Stromtrasse.

Quelle: Gutachten elektrische und magnetische 50-Hz-Felder Erstellung eines Immissionsgutachtens für magnetische und elektrische Felder im Rahmen der Erstellung der Genehmigungsunterlagen für das Planfeststellungsverfahren der geplanten Netzverstärkung Heilbronn-Ingelfingen NAP 2019 Projektnr. 4 Vorhaben 2: Heilbronn - Möckmühl.

In dem Gutachten (Abbildung unten) wurde 1 m über dem Boden gemessen. Die magnetische Flussdichte (B) mit 20 µT entspricht in etwa den Vorgaben des Arbeitskreises (Tabelle oben) mit 15 µT. Wenn der Sensor oberhalb (Vandalismus-sicher) am Freileitungsmast befestigt wird, sollte ausreichend Feldstärke vorhanden sein, ohne teure Messtechnik einsetzen zu müssen.

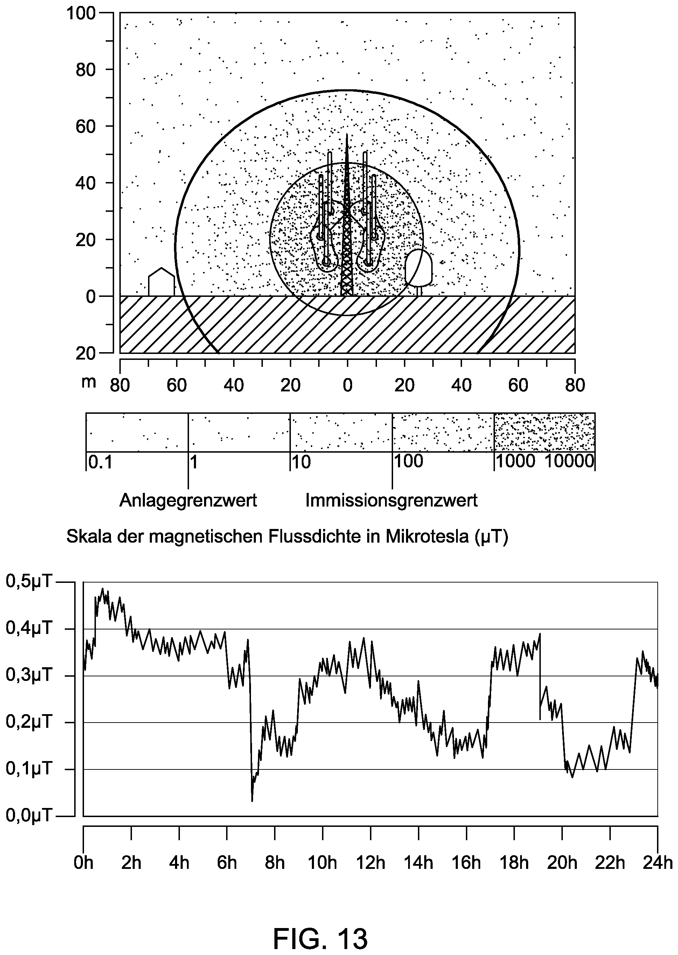

Fig. 13 zeigt einen Verlauf der magnetischen Flussdichte. Die Abstandsangaben auf den Achsen sind dabei in Metern angegeben.
Quelle:
https://www.bafu.admin.ch/bafu/de/home/themen/elektrosmog/fachinformationen/elektrosmog-quellen/hochspannungsleitungen--freileitungen--als-elektrosmog-quelle.htm1#:∼:text=Untef%20einer%20380%2DkV%2DHochspannungsleitung,bis%20zu%20400%20V%2Fm.

Die Fig. 13 zeigt oben einen Verlauf der magnetischen Flussdichte in der Ebene und unten den Verlauf der Feldstärkenamplitude über einen Tag. Die ist ein Beispiel für den zeitlichen Verlauf des Magnetfeldes in der Nähe einer 220-kV-Hochspannungsleitung während 24 Stunden an einem Werktag im Januar. Das Magnetfeld schwankt je nachdem, wie groß die Ströme sind, die die beiden Leitungsstränge führen.

Die Spannung bleibt konstant, die Stromstärke ändert sich je nach Verbrauch im Tagesverlauf. Die magnetische Flussdichte ist abhängig von der Stromstärke. Die verbrauchsabhängigen Schwankungen können bei der Überwachung in Ausführungsbeispielen berücksichtigt werden.

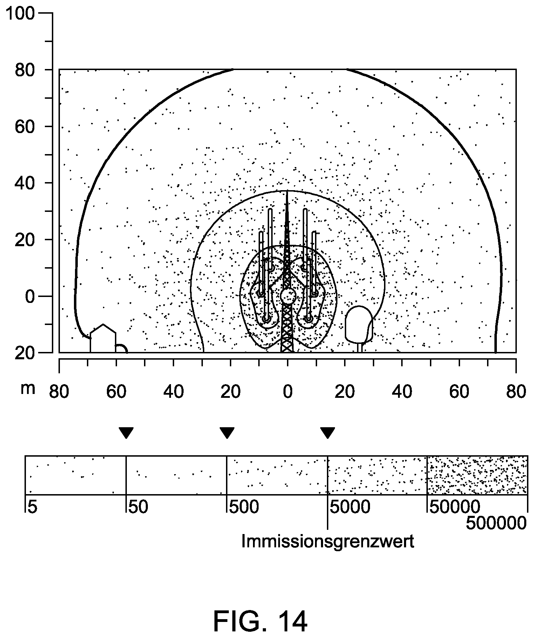

Die Fig. 14 zeigt einen Verlauf der elektrischen Feldstärke am Beispiel eines elektrischen Feldes einer Hochspannungsleitung.
Quelle:
https://www.bafu.admin.ch/bafu/de/home/themen/elektrosmog/fachinformationen/elektrosmogqellen/hochspannungsleitungen--freileitungen--als-elektrosmog-quelle.html#:∼:text=Unter%20einer%20380%2DkV%2DHochspannungsleitung,bis%20zu%20400%20V%2Fm
Die Fig. 14 zeigt die Abnahme der elektrischen Feldstärke von den Leitern bzw. Trassenmitte in einer Ebene rund um eine Leitertrasse. Die Abstandsangaben auf den Achsen sind dabei in Metern angegeben. Leitfähige Materialien in der Nähe des elektrischen Feldes können dieses beeinflussen, verzerren und abschwächen.

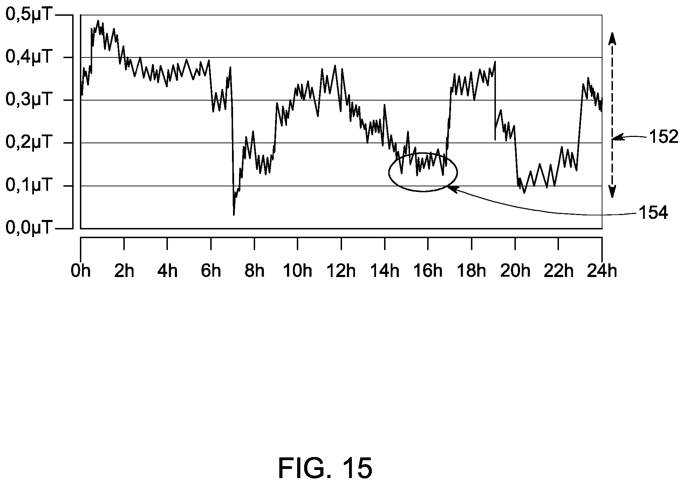

Fig. 15 zeigt einen zeitlichen Verlauf einer magnetischen Flussdichte über einen Tag.
Quelle: https://www.bafu.admin.ch/bafu/de/home/themen/elektrosmog/fachinformationen/elektrosmogquellen/hochspannungsleitungen-freileitungen-als-elektrosmog-quelle.html#:~:text=Unter%20einer%203 80%2DkV%2DHochspannungsleitung, bis%20zu%20400%20 V%2Fm
Fig. 15 zeigt die magnetische Flussdichte in µT aufgetragen über den 24h eines Tages. Gezeigt wird ein Beispiel für den zeitlichen Verlauf des Magnetfeldes in der Nähe einer 220-kV-Hochspannungsleitung während 24 Stunden an einem Werktag im Januar. Das Magnetfeld schwankt je nachdem, wie groß die Ströme sind, die in den beiden Leitungssträngen geführt werden.

Die Höhe der Flussdichte im Tagesverlauf unterliegt Schwankungen. Grund dafür ist der Strom (Energiemenge), der durch die Freileitung fließt und der von den Verbrauchern (z.B. Maschinen, Anlagen, Haushaltsgeräte) in unterschiedlichen Mengen konsumiert wird. Wie der Bereich 152 in der Fig. 15 zeigt, schwankt in Bodennähe die Flussdichte im Mittel um den Wert 0,3 µT, mit etwa +/- 0,2 µT. Der Bereich 154 zeigt, dass innerhalb kleiner Zeitintervalle (< 5 min) die Flussdichte nahezu konstant bleibt.

Für jede Leitung kann ein Tagesverlauf-abhängiges Muster für die Höhe der magnetischen Flussdichte erzeugt werden. Werden diese Muster miteinander verglichen, so lassen sich "Ist-Werte" innerhalb bestimmter Toleranzen, quasi ein "Gut-Zustand" davon ableiten. So kann beispielsweise im Rahmen einer statistischen Analyse eine Korrelation mit charakteristischen vorbekannten Verläufen mit Hilfe der Signalverarbeitungskomponenten 14, 24 durchgeführt werden. Überschreiten die Abweichungen eine gewisse Schwelle (oder liegt die Korrelation nicht ausreichend vor), so kann eine entsprechende Nachricht/Information generiert werden. Gibt es dramatische Änderungen (Kurzschluss), so wird diese Abweichung erkannt und es kann eine entsprechende Information darüber generiert werden.

Wie bereits oben erwähnt, kann in Ausführungsbeispielen auch eine Betrachtung zu Einflüssen von Umweltbedingungen erfolgen. Beispielsweise liegt die Temperaturgrenze für Leiterseile (Leitungen) bei 80 °C. Höhere Dauertemperaturen könnten zu einer Beschädigung der Leitungsseile führen. Bei der Stromübertragung kommt es zu "ohm'schen Verlusten", die sich quadratisch mit zunehmender Stromdichte erhöhen. Demnach haben sowohl Wind als auch die Außentemperatur Auswirkungen auf die Stromstärke. Der lokale Temperaturverlauf und die Windrichtung (Windstärke) ändern sich innerhalb weniger Minuten jedoch kaum. Lokale Windböen können in einem Modell in einem Ausführungsbeispiel mit Hilfe historischer Daten berücksichtigt werden.

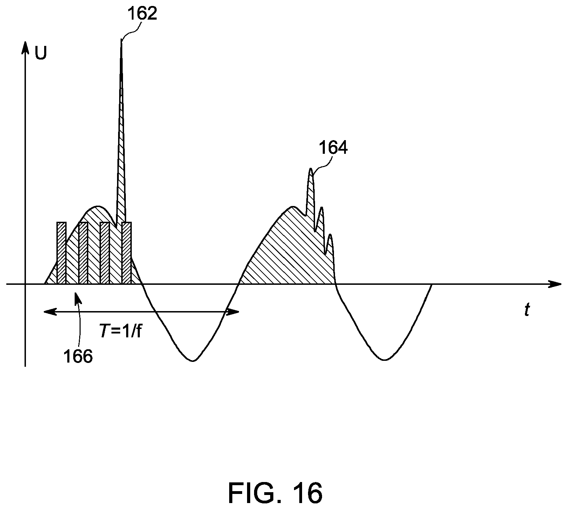

Fig. 16 zeigt eine Illustration von Überspannungspulsen.
Quelle: TU Darmstadt: 9_Energietechnik_V_20220404_Elektrische Energieversorgung
Fig. 16 zeigt einen Spannungsverlauf U über der Zeit t (Periodendauer t=l/f). In dem gezeigten Verlauf gibt es diverse Überspannungsimpulse. Dabei kann beispielsweise eine Blitzüberspannung (Dauer etwa 100µs) 162 vorkommen und auch eine Schaltüberspannung 164, gedämpft (f=100kHz-1MHz). Die Fig 16 zeigt schematisch die Abtastintervalle 166. Die Messung der Feldstärke erfolgt dauerhaft im Millisekundenbereich. Gemäß dem Nyquist-Shannon-Theorem muss die Abtastung mit einer Frequenz >100 Hz pro Sensor durchgeführt werden, um Änderungen bei 50 Hz zu erfassen. Um kleinere Änderungen im 100 µSek. Bereich erfassen zu können, wäre eine Abtastfrequenz von 10 kHz zu empfehlen. Die Nutzung eines 12-Bit A/D-Wandlers (Signalverarbeitungskomponente 14) sollte eine ausreichende Auflösung bieten.

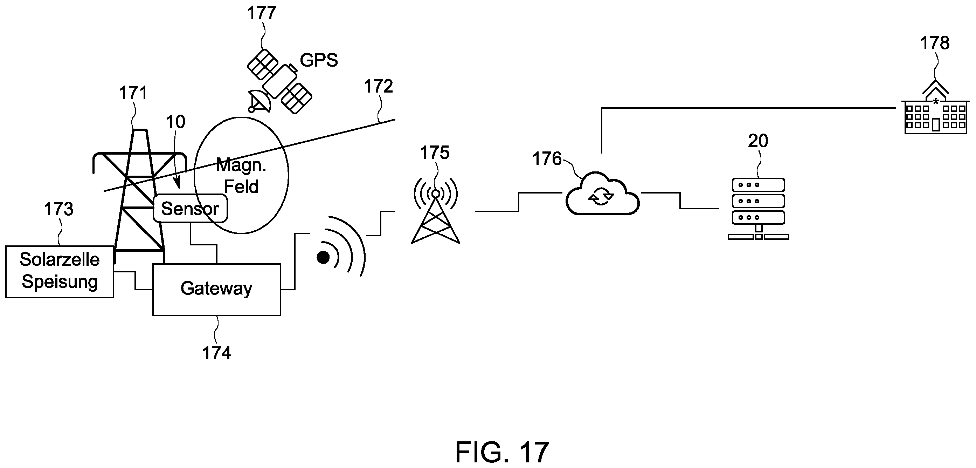

Ausführungsbeispiele schaffen auch ein Energieversorgungssystem mit ein oder mehreren Energieversorgungsleitungen, einer Halterung zur Positionierung einer Erfassungsvorrichtung 10 in einem definierten Abstand zu den Energieversorgungsleitungen, einer Erfassungsvorrichtung 10 gemäß der vorliegenden Beschreibung und einer Überwachungsvorrichtung 20 gemäß der vorliegenden Beschreibung. Die im Folgenden betrachteten Figuren 17, 18 und 19 zeigen Ausführungsbeispiele solcher Energieversorgungssysteme.

Fig. 17 zeigt eine Systemarchitektur in einem Ausführungsbeispiel. Fig. 17 zeigt einen Mast 171 der eine Energieversorgungsleitung 172 trägt. An dem Mast ist ein Ausführungsbeispiel einer Erfassungsvorrichtung 10 montiert, die über eine Solarzelle 173 gespeist wird und zumindest einen Sensor zur Erfassung des magnetischen Felds des Leiters 172 umfasst. Die Erfassungsvorrichtung 10 verfügt über zumindest eine Schnittstelle zu einem Gateway 174 und kommuniziert mit einem Ausführungsbeispiel einer Überwachungsvorrichtung 20, wobei ein öffentliches 4G/5G Mobilfunknetz 175 mit Internetzugang über VPN 176 (von engl. virtual private network) benutzt wird.

Die Erfassungsvorrichtung 10 mit dem Sensor übermittelt Daten (Ort- und Feldstärke, Ort beispielsweise über GPS 177 (von engl. Global Positioning System)) an das Gateway 174. Das Gateway 174 sendet die Daten über 5G sicher ins Rechenzentrum (Überwachungsvorrichtung 20). Das Netzwerk 175, 176 übermittelt in Echtzeit die Feldstärkewerte zur "KI", die im vorliegenden Ausführungsbeispiel in der Überwachungsvorrichtung 20 und die dortige Signalverarbeitungskomponente 24 implementiert ist. Die KI-Instanz 20 hat beispielsweise aus historischen Daten tagesaktuelle Muster (Soll-Zustand) gelernt und vergleicht mit den "Ist-Werten". Massive Änderungen werden der Leistelle 178 zur Prüfung mitgeteilt.

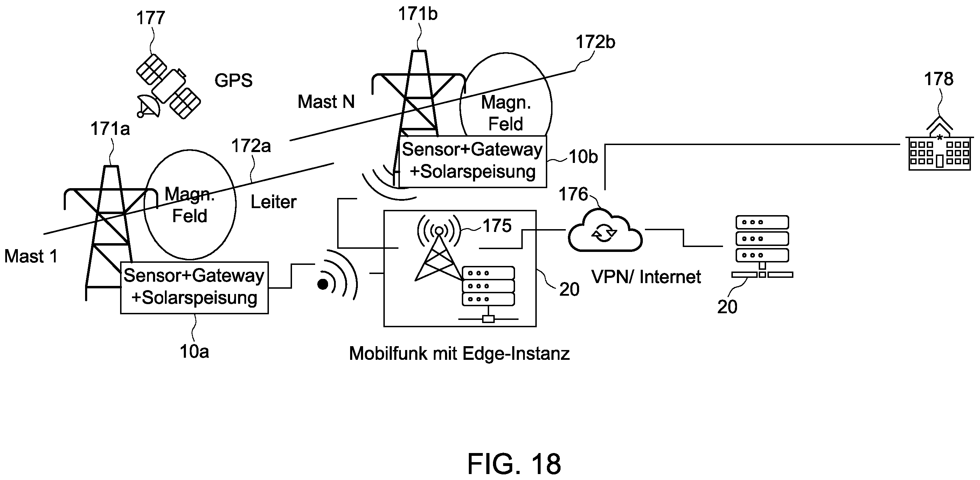

Fig. 18 zeigt eine alternative Systemarchitektur in einem Ausführungsbeispiel. Die Fig. 18 zeigt ähnliche Komponenten wie die Fig. 17, wobei gleiche Komponenten gleiche Bezugszeichen verwenden. Im Vergleich zur Fig. 17 werden in der Fig. 18 mehrere Maste 1..N betrachtet, die durch die Maste 171a, 171b repräsentiert werden. Analog tragen die Maste 171a, 171b die Leiter 172a, 172b und umfassen jeweils eine Erfassungsvorrichtung 10a, 10b, die wie in der Fig. 17 über die Sensorik, eine Solarenergieversorgung und ein Gateway verfügen. So werden quasi N (positiver ganzzahliger Wert) Bilder oder Signalverläufe erfasst und der Überwachungsvorrichtung 20 zur Auswertung bereitgestellt.

Eine Erfassungsvorrichtung 10a, 10b mit Sensor übermittelt Daten (Ort- und Feldstärke) an das Gateway. Das Gateway sendet Daten über 5G in einem Networkslice mit QoS (Quality of Service) in die Edge-Instanz 175. Dies geschieht für mehrere Maste, Mast 1, Mast 2, ...Mast N. Das Netzwerk 175, 176 übermittelt in Echtzeit die Feldstärkewerte zur Edge-Komponente zur Analyse. Im vorliegenden Ausführungsbeispiel übernimmt die Edge-Instanz 175 also einen Teil der Aufgaben der Überwachungsinstanz 20. Demnach können in manchen Ausführungsbeispielen Teile einer KI auch vorgelagert (näher beim Sensor) auf einem Edge-Server als Applikation betrieben werden und theoretisch kann dieser Edge-Server auch für andere Applikationen (Instanzen) verwendet werden und diesen Applikationen Rechenleistung zur Verfügung stellen. Die Edge-Komponente ist für mehrere Masten zuständig. Die Daten werden hier schneller verarbeitet. Die KI-Instanz 20 hat aus historischen Daten tagesaktuelle Muster (Soll-Zustand) gelernt und vergleicht mit den "Ist-Werten". Massive Änderungen werden der Leitstelle 178 zur Prüfung mitgeteilt. Die Verarbeitung in der Edge-Instanz kann sich dabei beispielsweise auf tages- und wetterabhängige Prognose-Werte beziehen, die von einer Datenbank oder einem Speicher der Überwachungsinstanz 20 der Edge-Instanz 175 übergeben werden.

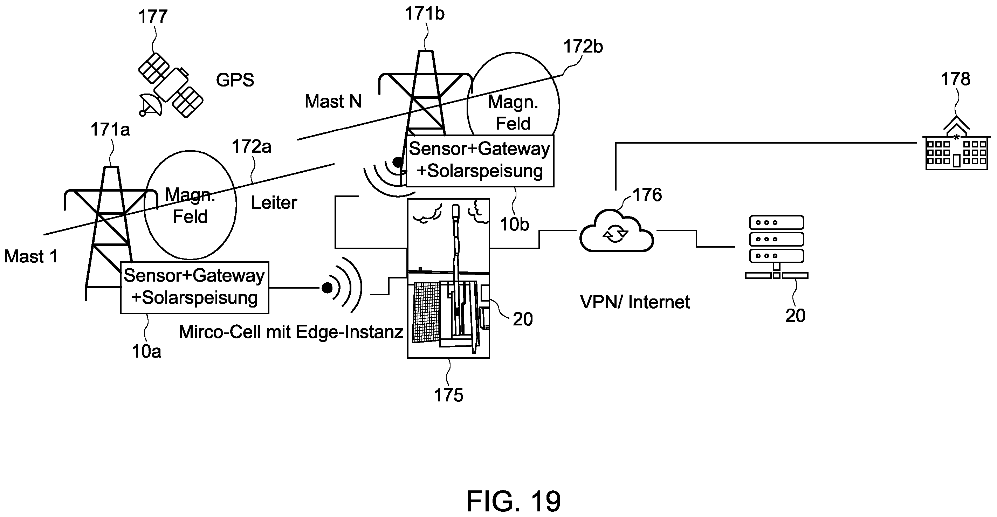

Fig. 19 zeigt eine weitere alternative Systemarchitektur in einem Ausführungsbeispiel. In diesem Ausführungsbeispiel befindet sich in der Edge-Instanz 175 eine Microzelle, die für einen temporären Einsatz vorgesehen ist. Bei dieser Variante kann der Energienetzbetreiber für den gewünschten Zeitraum Daten aus dem Versorgungsnetz mit eigenen Funkfrequenzen (5G) bekommen. Ansonsten entsprechen die Architektur und die Funktion der Anordnung der der Fig. 18.

Die oben beschriebene Microzelle kann beispielsweise zur 5G Versorgung eingesetzt werden. Dafür kann in einem Installationsrack oder -schrank ein entsprechender Bauraum vorgesehen sein, sodass die Microzelle dort temporär eingesetzt werden kann. Die Mikrozelle kann dann mit einer speziellen Antennenkonfiguration betrieben werden, z.B. eine intelligente Antenne mit ein bis drei Sektoren in kompakter Bauform. Denkbar wäre auch der Einsatz einer Microzelle an einem Fluggerät, wie einem Helikopter oder an einer Drohne. So könnten die Daten oder Informationen über die Feldgrößen auch über diesen Weg an die Überwachungsvorrichtung 20 kommuniziert werden. In weiteren Ausführungsbeispielen kann die Kommunikation auch über eine Satellitenverbindung erfolgen oder eine andere Funkverbindung bewerkstelligt werden.

In Ausführungsbeispielen können nahezu beliebige Feldsensoren zum Einsatz kommen. Als Magnetfeldsonden kommen beispielsweise Magnetsonden in Frage, die drei Sensoren bestehen, mit denen die Raumrichtung der magnetischen Flussdichte gemessen werden kann. Je nach Sensortyp liegt der Messbereich zwischen +/- 20 mT bis zu +/-2000 mT mit einem Linearitätsfehler von <0,5%. Beispielsweise werden die Signale aus den einzelnen Sensoren werden zu einem Gesamtsignal addiert (Superposition), da zumindest in manchen Ausführungsbeispielen nur der Betrag der Flussdichte ausgewertet wird. In anderen Ausführungsbeispielen ist auch eine Auswertung der Richtung denkbar, beispielsweise wenn auch eine Auslenkung aufgrund der Windlast detektiert werden so und so das Feld Richtungsschwankungen aufweist, die auf die Pendelbewegung der Leitung zurückgehen. Für den Einsatz in dem hier vordergründig betrachteten Konzept ist primär nur die absolute Stärke des magnetischen/elektrischen Feldes und etwaige Änderungen relevant in Abhängigkeit der Zeit.

Ähnliche Sonden sind auch zur Detektion von elektrischen Feldern im niederfrequenten Bereich auf allen 3 Achsen denkbar. Der Messbereich solcher Sonden liegt zwischen 0-20 V/m, 0-200 V/m und 0-2000 V/m bei einer Empfindlichkeit von ca. 0,05V/m (Unsicherheit ca. +/-5 %). Alternativ könnte auch ein "Messgerät" mit einer digitalen Schnittstelle (z.B. USB) verwendet werden, um das elektrische Feld zu messen.

Die Aspekte und Merkmale, die im Zusammenhang mit einem bestimmten der vorherigen Beispiele beschrieben sind, können auch mit einem oder mehreren der weiteren Beispiele kombiniert werden, um ein identisches oder ähnliches Merkmal dieses weiteren Beispiels zu ersetzen oder um das Merkmal in das weitere Beispiel zusätzlich einzuführen.

Beispiele können weiterhin ein (Computer-)Programm mit einem Programmcode zum Ausführen eines oder mehrerer der obigen Verfahren sein oder sich darauf beziehen, wenn das Programm auf einem Computer, einem Prozessor oder einer sonstigen programmierbaren Hardwarekomponente ausgeführt wird. Schritte, Operationen oder Prozesse von verschiedenen der oben beschriebenen Verfahren können also auch durch programmierte Computer, Prozessoren oder sonstige programmierbare Hardwarekomponenten ausgeführt werden. Beispiele können auch Programmspeichervorrichtungen, z.B. Digitaldatenspeichermedien, abdecken, die maschinen-, prozessor- oder computerlesbar sind und maschinenausführbare, prozessorausführbare oder computerausführbare Programme und Anweisungen codieren beziehungsweise enthalten. Die Programmspeichervorrichtungen können z.B. Digitalspeicher, magnetische Speichermedien wie beispielsweise Magnetplatten und Magnetbänder, Festplattenlaufwerke oder optisch lesbare Digitaldatenspeichermedien umfassen oder sein. Weitere Beispiele können auch Computer, Prozessoren, Steuereinheiten, feld-programmierbare Logik-Arrays ((F)PLAs = (Field) Programmable Logic Arrays), feld-programmierbare Gate-Arrays ((F)PGA = (Field) Programmable Gate Arrays), Grafikprozessoren (GPU = Graphics Processor Unit), anwendungsspezifische integrierte Schaltungen (ASIC = application-specific integrated circuit), integrierte Schaltungen (IC= Integrated Circuit) oder Ein-Chip-Systeme (SoC = System-on-a-Chip) abdecken, die zum Ausführen der Schritte der oben beschriebenen Verfahren programmiert sind.

Es versteht sich ferner, dass die Offenbarung mehrerer, in der Beschreibung oder den Ansprüchen offenbarter Schritte, Prozesse, Operationen oder Funktionen nicht als zwingend in der beschriebenen Reihenfolge befindlich ausgelegt werden soll, sofern dies nicht im Einzelfall explizit angegeben oder aus technischen Gründen zwingend erforderlich ist. Daher wird durch die vorhergehende Beschreibung die Durchführung von mehreren Schritten oder Funktionen nicht auf eine bestimmte Reihenfolge begrenzt. Ferner kann bei weiteren Beispielen ein einzelner Schritt, eine einzelne Funktion, ein einzelner Prozess oder eine einzelne Operation mehrere Teilschritte, -funktionen, -prozesse oder -operationen einschließen und/oder in dieselben aufgebrochen werden.

Wenn einige Aspekte in den vorhergehenden Abschnitten im Zusammenhang mit einer Vorrichtung oder einem System beschrieben wurden, sind diese Aspekte auch als eine Beschreibung des entsprechenden Verfahrens zu verstehen. Dabei kann beispielsweise ein Block, eine Vorrichtung oder ein funktionaler Aspekt der Vorrichtung oder des Systems einem Merkmal, etwa einem Verfahrensschritt, des entsprechenden Verfahrens entsprechen. Entsprechend dazu sind Aspekte, die im Zusammenhang mit einem Verfahren beschrieben werden, auch als eine Beschreibung eines entsprechenden Blocks, eines entsprechenden Elements, einer Eigenschaft oder eines funktionalen Merkmals einer entsprechenden Vorrichtung oder eines entsprechenden Systems zu verstehen.

Die folgenden Ansprüche werden hiermit in die detaillierte Beschreibung aufgenommen, wobei jeder Anspruch als getrenntes Beispiel für sich stehen kann. Ferner ist zu beachten, dass - obwohl ein abhängiger Anspruch sich in den Ansprüchen auf eine bestimmte Kombination mit einem oder mehreren anderen Ansprüchen bezieht - andere Beispiele auch eine Kombination des abhängigen Anspruchs mit dem Gegenstand jedes anderen abhängigen oder unabhängigen Anspruchs umfassen können. Solche Kombinationen werden hiermit explizit vorgeschlagen, sofern nicht im Einzelfall angegeben ist, dass eine bestimmte Kombination nicht beabsichtigt ist. Ferner sollen auch Merkmale eines Anspruchs für jeden anderen unabhängigen Anspruch eingeschlossen sein, selbst wenn dieser Anspruch nicht direkt als abhängig von diesem anderen unabhängigen Anspruch definiert ist.

## Patentansprüche

1. Eine Erfassungsvorrichtung (10) zur Erfassung von Information über einen Signalverlaufs in einer Energieversorgungsleitung, mit
ein oder mehreren Sensorelementen (12), die ausgebildet sind, um einen zeitlichen Verlauf einer für den Signalverlauf charakteristischen Feldgröße in einem Abstand von der Energieversorgungsleitung zu detektieren;
ein oder mehreren Schnittstellen (16), die ausgebildet sind, um Information über den zeitlichen Verlauf der Feldgröße in einem Kommunikationsnetzwerk zu kommunizieren; und
ein oder mehreren Signalverarbeitungskomponenten (14), die ausgebildet sind, um über die ein oder mehreren Sensorelemente (12) den zeitlichen Verlauf der Feldgröße zu erfassen, um Information über den zeitlichen Verlauf der Feldgröße zu generieren und um die Information über den zeitlichen Verlauf der Feldgröße über die ein oder mehreren Schnittstellen (16) in dem Kommunikationsnetzwerk zu kommunizieren.

2. Die Erfassungsvorrichtung (10) gemäß Anspruch 1, wobei die ein oder mehreren Sensorelemente (12) ausgebildet sind, um ein elektrisches Feld oder ein magnetisches Feld der Energieversorgungleitung als Feldgröße zu detektieren.

3. Die Erfassungsvorrichtung (10) gemäß einem der Ansprüche 1 oder 2, wobei die ein oder mehreren Sensorelemente (12) ausgebildet sind, um die Feldgröße in einem vorbestimmten Abstand an einer freien Energieversorgungsleitung zu detektieren.

4. Die Erfassungsvorrichtung (10) gemäß einem der vorangehenden Ansprüche, wobei die ein oder mehreren Signalverarbeitungskomponenten (14) ausgebildet sind, um die ein oder mehreren zeitlichen Verläufe über die ein oder mehreren Sensorelemente (12) analog zu erfassen und digital zu wandeln, wobei eine Signalabtastung zur digitalen Wandlung mit mehr als 100Hz erfolgt.

5. Die Erfassungsvorrichtung (10) gemäß einem der vorangehenden Ansprüche, die ausgebildet ist, um eine Mehrzahl von Signalverläufen in einer Mehrzahl von Energieversorgungsleitungen zu erfassen, wobei die ein oder mehreren Sensorelemente (12) ausgebildet sind, um mehrere Feldgrößen zu detektieren, die für die Signalverläufe in den Energieversorgungsleitungen charakteristisch sind,
wobei die ein oder mehreren Schnittstellen (16) ausgebildet sind, um Information über die zeitlichen Verläufe der mehreren Feldgrößen in dem Kommunikationsnetzwerk zu kommunizieren, und
wobei die ein oder mehreren Signalverarbeitungskomponenten (14), ausgebildet sind, um über die ein oder mehreren Sensorelemente (12) mehrere zeitliche Verläufe der Feldgrößen zu detektieren, um Information über die zeitlichen Verläufe der Feldgrößen zu generieren und um die Information über die mehreren zeitlichen Verläufe der Feldgrößen über die ein oder mehreren Schnittstellen (16) in dem Kommunikationsnetzwerk zu kommunizieren.

6. Eine Überwachungsvorrichtung (20) zur Überwachung von ein oder mehreren Signalverläufen in ein oder mehreren Energieversorgungsleitungen, mit
ein oder mehreren Schnittstellen (26), die ausgebildet sind, um Information über ein oder mehrere zeitliche Verläufe von Feldgröße/-n über ein Kommunikationsnetzwerk zu erhalten; und
ein oder mehreren Signalverarbeitungskomponenten (24), die ausgebildet sind, um über die ein oder mehreren Schnittstellen (26), die Information über die ein oder mehreren zeitlichen Verläufe der Feldgrößen zu erhalten,
wobei die ein oder mehreren Signalverarbeitungskomponenten (24) ferner ausgebildet sind, um in den ein oder mehreren zeitlichen Verläufen eine Normabweichung zu detektieren und um eine Information über die Normabweichung zu generieren.

7. Die Überwachungsvorrichtung (20) gemäß Anspruch 6, wobei die ein oder mehreren Signalverarbeitungskomponenten (24) ausgebildet sind, um die Normabweichung durch Vergleich der ein oder mehreren zeitlichen Verläufe der Feldgröße/-n mit statistisch erwarteten zeitlichen Verläufen der Feldgröße/-n zu detektieren.

8. Die Überwachungsvorrichtung (20) gemäß Anspruch 7, wobei die ein oder mehreren Signalverarbeitungskomponenten (24) ausgebildet sind, um bei dem Vergleich Auswirkungen aktueller Umgebungsbedingungen auf die ein oder mehreren zeitlichen Verläufe der Feldgrößen zu berücksichtigen.

9. Die Überwachungsvorrichtung (20) gemäß einem der Ansprüche 6 bis 8, wobei die ein oder mehreren Signalverarbeitungskomponenten (24) ausgebildet sind, um über die ein oder mehreren zeitlichen Verläufe der Feldgrößen einen Kurzschluss oder eine Unterbrechung einer Energieversorgungsleitung zu detektieren und eine Information über den Kurzschluss oder die Unterbrechung und dessen/deren Ort zu generieren.

10. Eine Halterung zur Montage einer Erfassungsvorrichtung (10) gemäß einem der Ansprüche 1 bis 5 relativ zu einer Energieversorgungsleitung in einem definierten Abstand.

11. Die Halterung gemäß Anspruch 10, wobei die Halterung ausgebildet ist, um die Erfassungsvorrichtung (10) außerhalb einer Schutzzone für die Energieversorgungsleitung zu montieren.

12. Ein Energieversorgungssystem mit ein oder mehreren Energieversorgungsleitungen, einer Halterung gemäß einem der Ansprüche 10 oder 11, einer Erfassungsvorrichtung (10) gemäß einem der Ansprüche 1 bis 5 und einer Überwachungsvorrichtung (20) gemäß einem der Ansprüche 6 bis 9.

13. Ein Erfassungsverfahren (30) zur Erfassung von Information über einen Signalverlauf in einer Energieversorgungsleitung, mit
Detektieren (32) eines zeitlichen Verlaufs einer für den Signalverlauf charakteristischen Feldgröße in einem Abstand von der Energieversorgungsleitung;
Generieren (34) von Information über den zeitlichen Verlauf der Feldgröße; und
Kommunizieren (36) der Information über den zeitlichen Verlauf der Feldgröße in einem Kommunikationsnetzwerk.

14. Ein Überwachungsverfahren (40) zur Überwachung von ein oder mehreren Signalverläufen in ein oder mehreren Energieversorgungsleitungen, mit
Erhalten (42) von Information über ein oder mehrere zeitliche Verläufe von Feldgrößen über ein Kommunikationsnetzwerk;
Detektieren (44) einer Normabweichung in den ein oder mehreren zeitlichen Verläufen; und
Generieren (46) einer Information über die Normabweichung.

15. Ein Computerprogramm mit einem Programmcode zur Durchführung eines der Verfahren (30; 40) gemäß einem der Ansprüche 13 oder 14, wenn der Programmcode auf einem Computer, einem Prozessor oder einer programmierbaren Hardwarekomponente ausgeführt wird.

## Geänderte Patentansprüche

### Geänderte Patentansprüche gemäss Regel 137(2) EPÜ.

1. Eine Erfassungsvorrichtung (10) zur Erfassung von Information über einen Signalverlauf in einer Energieversorgungsleitung, mit
ein oder mehreren Sensorelementen (12), die ausgebildet sind, um einen zeitlichen Verlauf einer für den Signalverlauf charakteristischen Feldgröße in einem Abstand von der Energieversorgungsleitung zu detektieren, wobei die ein oder mehreren Sensorelemente (12) ausgebildet sind, um die Feldgröße in einem vorbestimmten Abstand außerhalb einer Schutzzone an einer freien Energieversorgungsleitung zu detektieren;
ein oder mehreren Schnittstellen (16), die ausgebildet sind, um Information über den zeitlichen Verlauf der Feldgröße in einem Kommunikationsnetzwerk zu kommunizieren; und
ein oder mehreren Signalverarbeitungskomponenten (14), die ausgebildet sind, um über die ein oder mehreren Sensorelemente (12) den zeitlichen Verlauf der Feldgröße zu erfassen, um Information über den zeitlichen Verlauf der Feldgröße zu generieren und um die Information über den zeitlichen Verlauf der Feldgröße über die ein oder mehreren Schnittstellen (16) in dem Kommunikationsnetzwerk zu kommunizieren.

2. Die Erfassungsvorrichtung (10) gemäß Anspruch 1, wobei die ein oder mehreren Sensorelemente (12) ausgebildet sind, um ein elektrisches Feld oder ein magnetisches Feld der Energieversorgungleitung als Feldgröße zu detektieren.

3. Die Erfassungsvorrichtung (10) gemäß einem der vorangehenden Ansprüche, wobei die ein oder mehreren Signalverarbeitungskomponenten (14) ausgebildet sind, um die ein oder mehreren zeitlichen Verläufe über die ein oder mehreren Sensorelemente (12) analog zu erfassen und digital zu wandeln, wobei eine Signalabtastung zur digitalen Wandlung mit mehr als 100Hz erfolgt.

4. Die Erfassungsvorrichtung (10) gemäß einem der vorangehenden Ansprüche, die ausgebildet ist, um eine Mehrzahl von Signalverläufen in einer Mehrzahl von Energieversorgungsleitungen zu erfassen, wobei die ein oder mehreren Sensorelemente (12) ausgebildet sind, um mehrere Feldgrößen zu detektieren, die für die Signalverläufe in den Energieversorgungsleitungen charakteristisch sind,
wobei die ein oder mehreren Schnittstellen (16) ausgebildet sind, um Information über die zeitlichen Verläufe der mehreren Feldgrößen in dem Kommunikationsnetzwerk zu kommunizieren, und
wobei die ein oder mehreren Signalverarbeitungskomponenten (14), ausgebildet sind, um über die ein oder mehreren Sensorelemente (12) mehrere zeitliche Verläufe der Feldgrößen zu detektieren, um Information über die zeitlichen Verläufe der Feldgrößen zu generieren und um die Information über die mehreren zeitlichen Verläufe der Feldgrößen über die ein oder mehreren Schnittstellen (16) in dem Kommunikationsnetzwerk zu kommunizieren.

5. Eine Überwachungsvorrichtung (20) zur Überwachung von ein oder mehreren Signalverläufen in ein oder mehreren Energieversorgungsleitungen, mit
ein oder mehreren Schnittstellen (26), die ausgebildet sind, um Information über ein oder mehrere zeitliche Verläufe von Feldgröße/-n über ein Kommunikationsnetzwerk zu erhalten, wobei die Feldgröße/-n in einem vorbestimmten Abstand außerhalb einer Schutzzone an einer freien Energieversorgungsleitung detektiert wurden; und
ein oder mehreren Signalverarbeitungskomponenten (24), die ausgebildet sind, um über die ein oder mehreren Schnittstellen (26), die Information über die ein oder mehreren zeitlichen Verläufe der Feldgrößen zu erhalten,
wobei die ein oder mehreren Signalverarbeitungskomponenten (24) ferner ausgebildet sind, um in den ein oder mehreren zeitlichen Verläufen eine Normabweichung zu detektieren und um eine Information über die Normabweichung zu generieren.

6. Die Überwachungsvorrichtung (20) gemäß Anspruch 5, wobei die ein oder mehreren Signalverarbeitungskomponenten (24) ausgebildet sind, um die Normabweichung durch Vergleich der ein oder mehreren zeitlichen Verläufe der Feldgröße/-n mit statistisch erwarteten zeitlichen Verläufen der Feldgröße/-n zu detektieren.

7. Die Überwachungsvorrichtung (20) gemäß Anspruch 6, wobei die ein oder mehreren Signalverarbeitungskomponenten (24) ausgebildet sind, um bei dem Vergleich Auswirkungen aktueller Umgebungsbedingungen auf die ein oder mehreren zeitlichen Verläufe der Feldgrößen zu berücksichtigen.

8. Die Überwachungsvorrichtung (20) gemäß einem der Ansprüche 5 bis 7, wobei die ein oder mehreren Signalverarbeitungskomponenten (24) ausgebildet sind, um über die ein oder mehreren zeitlichen Verläufe der Feldgrößen einen Kurzschluss oder eine Unterbrechung einer Energieversorgungsleitung zu detektieren und eine Information über den Kurzschluss oder die Unterbrechung und dessen/deren Ort zu generieren.

9. Eine Halterung zur Montage einer Erfassungsvorrichtung (10) gemäß einem der Ansprüche 1 bis 4 relativ zu einer Energieversorgungsleitung in einem definierten Abstand, wobei die Halterung ausgebildet ist, um die Erfassungsvorrichtung (10) außerhalb einer Schutzzone für die Energieversorgungsleitung zu montieren.

10. Ein Energieversorgungssystem mit ein oder mehreren Energieversorgungsleitungen, einer Halterung gemäß Anspruch 9, einer Erfassungsvorrichtung (10) gemäß einem der Ansprüche 1 bis 5 und einer Überwachungsvorrichtung (20) gemäß einem der Ansprüche 6 bis 9.

11. Ein Erfassungsverfahren (30) zur Erfassung von Information über einen Signalverlauf in einer Energieversorgungsleitung, mit
Detektieren (32) eines zeitlichen Verlaufs einer für den Signalverlauf charakteristischen Feldgröße in einem Abstand von der Energieversorgungsleitung, wobei der Abstand ein vorbestimmter Abstand außerhalb einer Schutzzone der freien Energieversorgungsleitung ist;
Generieren (34) von Information über den zeitlichen Verlauf der Feldgröße; und Kommunizieren (36) der Information über den zeitlichen Verlauf der Feldgröße in einem Kommunikationsnetzwerk.

12. Ein Überwachungsverfahren (40) zur Überwachung von ein oder mehreren Signalverläufen in ein oder mehreren Energieversorgungsleitungen, mit Erhalten (42) von Information über ein oder mehrere zeitliche Verläufe von Feldgrößen über ein Kommunikationsnetzwerk, wobei eine Feldgröße in einem vorbestimmten Abstand außerhalb einer Schutzzone an einer freien Energieversorgungsleitung detektiert wurde;
Detektieren (44) einer Normabweichung in den ein oder mehreren zeitlichen Verläufen; und
Generieren (46) einer Information über die Normabweichung.

13. Ein Computerprogramm mit einem Programmcode zur Durchführung eines der Verfahren (30; 40) gemäß einem der Ansprüche 13 oder 14, wenn der Programmcode auf einem Computer, einem Prozessor oder einer programmierbaren Hardwarekomponente ausgeführt wird.
